# EUROPEAN PATENT APPLICATION

(11) **EP 1 788 615 A2**
(43) Date of publication of application: **23.05.2007**
(21) Application number: 06255848.1
(22) Date of filing: 15.11.2006
(51) Int. Cl.: H01L 21/00

(54) **Substrate treatment apparatus and substrate treatment method**

(30) Priority: 17.11.2005 JP 2005332336
(71) Applicant: E-Beam Corporation, Minato-ku Tokyo 108-0075 (JP)
(72) Inventor: Shinozaki, Hiroyuki, e-BEAM Corporation, Tokyo 108-0075 (JP); Yamaguchi, Norihiro, e-BEAM Corporation, Tokyo 108-0075 (JP); Watanabe, Katushide, e-BEAM Corporation, Tokyo 108-0075 (JP)
(74) Representative: Waldren, Robin Michael

(57) **Abstract**

A substrate treatment apparatus is disclosed. The substrate treatment apparatus has an electrostatic chuck mechanism, a grounding mechanism, and an electron beam radiating mechanism. The electrostatic chuck mechanism electrostatically sucks and holds a substrate under treatment. The grounding mechanism freely contacts a predetermined film of a plurality of films formed on a treatment surface of the substrate under treatment sucked and held by the electrostatic chuck mechanism. The electron beam radiating mechanism radiates a resist film formed on the treatment surface side of the substrate under treatment with an electron beam.

## Description

### Background of the Invention

### 1. Field of the Invention

The present invention relates to a substrate treatment apparatus and a substrate treatment method.

### 2. Description of the Related Art

A device that electrostatically sucks and holds a semiconductor wafer 1' on a dielectric 2', causes a push spring 6' to push a grounding electrode 7' on a treatment surface of the semiconductor wafer 1' held on the dielectric 2', and radiates the treatment surface of the semiconductor wafer 1' with an electron beam is known for example as disclosed in Japanese Patent Application Unexamined Publication No. 11-67884 (see Fig. 1 of this related art reference).

### Summary of the Invention

However, in the foregoing device (disclosed in the foregoing patent document), to prevent electrons of the electron beam from being stored on the semiconductor wafer 1', the grounding electrode 7' is pushed onto the semiconductor wafer 1', namely silicon (Si), a circuit pattern or a resist film formed on silicon (Si) is remarkably damaged as a problem.

In addition, the rear surface of the semiconductor wafer 1' is electrostatically sucked and held by the dielectric 2'. Static electricity of the dielectric 2' is stored in the semiconductor wafer 1'. The stored static electricity adversely affects the path of the electron beam. As a problem of the related art reference, the yield of semiconductor wafers 1' in the exposing process deteriorates.

In addition, although the rear surface of the semiconductor wafer 1' is electrostatically sucked and held by the dielectric 2', when the semiconductor wafer 1' is separated from the dielectric 2', static electricity cannot be sufficiently removed by grounding the treatment surface of the semiconductor wafer 1' with the grounding electrode 7'. As another problem of the related art reference, when the semiconductor wafer 1' is separated from the dielectric 2', the semiconductor wafer 1' is damaged.

In addition, since the semiconductor wafer 1' is damaged and scattered in the treatment chamber, it is necessary to take a time for maintenance of the treatment chamber. Thus, not only the working efficiency, but the throughput of the treatment lowers.

In view of the foregoing, it would be desirable to provide a substrate treatment apparatus and a substrate treatment method that prevent electrostatic sucking from adversely affecting a substrate under treatment, improve the throughput of treatments for a substrate under treatment, effectively diselectrify the substrate under treatment, namely remove electrons which are present on the substrate under treatment radiated with an electron beam, and improve the yield of substrates under treatment.

According to an embodiment of the present invention, there is provided a substrate treatment apparatus having an electrostatic chuck mechanism, a grounding mechanism, and an electron beam radiating mechanism. The electrostatic chuck mechanism electrostatically sucks and holds a substrate under treatment. The grounding mechanism freely contacts a predetermined film of a plurality of films formed on a treatment surface of the substrate under treatment sucked and held by the electrostatic chuck mechanism. The electron beam radiating mechanism radiates a resist film formed on the treatment surface side of the substrate under treatment with an electron beam.

According to an embodiment of the present invention, there is provided a substrate treatment apparatus having an electrostatic chuck mechanism, a grounding mechanism, an electron beam radiating mechanism, and an eddy current suppressing mechanism. The electrostatic chuck mechanism electrostatically sucks and holds a substrate under treatment. The grounding mechanism freely contacts a predetermined film of a plurality of films formed on a treatment surface of the substrate under treatment sucked and held by the electrostatic chuck mechanism. The electron beam radiating mechanism radiates a resist film formed on the treatment surface side of the substrate under treatment with an electron beam. The eddy current suppressing mechanism is disposed around the substrate under treatment sucked by the electrostatic chuck mechanism. The eddy current suppressing mechanism suppresses occurrence of an eddy current in the substrate under treatment.

According to an embodiment of the present invention, there is provided a substrate treatment apparatus having an electrostatic chuck mechanism, a first grounding mechanism, a second grounding mechanism, and an electron beam radiating mechanism. The electrostatic chuck mechanism electrostatically sucks and holds a substrate under treatment. The first grounding mechanism freely contacts a predetermined film of a plurality of films formed on a treatment surface of the substrate under treatment sucked and held by the electrostatic chuck mechanism. The second grounding mechanism freely contacts the rear surface of the substrate under treatment sucked and held by the electrostatic chuck mechanism. The electron beam radiating mechanism radiates a resist film formed on the treatment surface side of the substrate under treatment with an electron beam.

According to an embodiment of the present invention, there is provided a substrate treatment apparatus having an electrostatic chuck mechanism, a first grounding mechanism, a second grounding mechanism, and an electron beam radiating mechanism. The electrostatic chuck mechanism electrostatically sucks and holds a substrate under treatment. The first grounding mechanism freely contacts a predetermined film of a plurality of films formed on a treatment surface of the substrate under treatment at a first position on the treatment surface side of the substrate under treatment sucked and held by the electrostatic chuck mechanism. The second grounding mechanism freely contacts the substrate under treatment at a second position on the rear surface side of the substrate under treatment sucked and held by the electrostatic chuck mechanism. The second position is opposite to the first position. The second position deviates from the first position. The electron beam radiating mechanism radiates a resist film formed on the treatment surface side of the substrate under treatment with an electron beam.

According to an embodiment of the present invention, there is provided a substrate treatment apparatus having an electrostatic chuck mechanism, a first grounding mechanism, a second grounding mechanism, and an electron beam radiating mechanism. The electrostatic chuck mechanism electrostatically sucks and holds a substrate under treatment. The first grounding mechanism freely contacts a predetermined film of a plurality of films formed on a treatment surface of the substrate under treatment at a first position on the treatment surface side of the substrate under treatment sucked and held by the electrostatic chuck mechanism. The second grounding mechanism freely contacts the substrate under treatment at a second position on the rear surface side of the substrate under treatment sucked and held by the electrostatic chuck mechanism. The second position is opposite to the first position. The second position deviates from the first position. The second position is closer to the center position of the substrate under treatment than the first position. The electron beam radiating mechanism radiates a resist film formed on the treatment surface side of the substrate under treatment with an electron beam.

According to an embodiment of the present invention, there is provided a substrate treatment method of performing an exposing treatment for a substrate under treatment. A grounding mechanism is caused to contact a treatment surface of the substrate under treatment. An electrostatic chuck mechanism disposed on a holding table is caused to electrostatically suck the substrate under treatment. The grounding mechanism is caused to contact a rear surface of the substrate under treatment sucked and held by the electrostatic chuck mechanism. An exposing treatment is performed for the substrate under treatment.

According to an embodiment of the present invention, there is provided a substrate treatment method of performing an exposing treatment for a substrate under treatment. A grounding mechanism is caused to contact a grounding mechanism at a first position on a treatment surface side of the substrate under treatment. An electrostatic chuck mechanism disposed on a holding table is caused to electrostatically suck the substrate under treatment. The grounding mechanism is caused to contact the substrate under treatment at a second position on the rear surface side of the substrate under treatment sucked and held by the electrostatic chuck mechanism. The second position is opposite to the first position. The second position deviates from the first position. The second position is closer to the center position of the substrate under treatment than the first position. An exposing treatment is performed for the substrate under treatment.

According to an embodiment of the present invention, there is provided a substrate treatment method of performing an exposing treatment for a substrate under treatment. A grounding mechanism is caused to contact a grounding mechanism at a first position on a treatment surface side of the substrate under treatment. An electrostatic chuck mechanism disposed on a holding table is caused to electrostatically suck the substrate under treatment. The grounding mechanism is caused to contact the substrate under treatment at a second position on the rear surface side of the substrate under treatment sucked and held by the electrostatic chuck mechanism. The second position is opposite to the first position. The second position deviates from the first position. An exposing treatment is performed for the substrate under treatment.

According to an embodiment of the present invention, there is provided a substrate treatment method of treating a substrate under treatment. A grounding mechanism is caused to contact a treatment surface of the substrate under treatment in a holding area of a holding table which holds a treatment surface side of the substrate under treatment. An electrostatic chuck mechanism disposed on the holding table is caused to electrostatically suck the substrate under treatment held by the holding table. The grounding mechanism is caused to contact a rear surface of the substrate under treatment. An exposing treatment is performed for the substrate under treatment.

According to an embodiment of the present invention, there is provided a substrate treatment method of treating a substrate under treatment. The substrate under treatment is caused to be placed on a holding table having an electrostatic chuck mechanism with a plurality of electrodes that electro-statically sucks the substrate under treatment. A grounding mechanism is caused to contact a treatment surface of the substrate under treatment. A plurality of voltages are caused to be applied to the plurality of electrodes so as to cause the electrostatic chuck mechanism to electrostatically suck the substrate under treatment. The grounding mechanism is caused to contact a rear surface of the substrate under treatment. A single voltage is caused to be applied to the plurality of electrodes so as to cause the electrostatic chuck mechanism to electrostatically suck the substrate under treatment. An exposing treatment is performed for the substrate under treatment.

According to an embodiment of the present invention, there is provided a substrate treatment method of treating a substrate under treatment. The substrate under treatment is caused to be placed on a holding table having an electrostatic chuck mechanism with a plurality of electrodes that electro-statically sucks the substrate under treatment. A grounding mechanism is caused to contact a treatment surface of the substrate under treatment. A single voltage is caused to be applied to the plurality of electrodes so as to cause the electrostatic chuck mechanism to electrostatically suck the substrate under treatment. The grounding mechanism is caused to contact a rear surface of the substrate under treatment. A single voltage is caused to be applied to the plurality of electrodes so as to cause the electrostatic chuck mechanism to electrostatically suck the substrate under treatment. The grounding mechanism is caused to contact a rear surface of the substrate under treatment. The same voltage is caused to be applied to a first electrode and a second electrode of a plurality of electrodes so as to cause the electrostatic chuck mechanism to electrostatically suck the substrate under treatment on the electrostatic sucking device. The first electrode is apart from the contact position of the grounding mechanism. The second electrode is close to the contact position of the grounding mechanism. An exposing treatment is performed for the substrate under treatment.

According to embodiments of the present invention, there is provided a substrate treatment apparatus and a substrate treatment method are provided, that prevent electrostatic sucking from adversely affecting a substrate under treatment, improve the throughput of treatments for a substrate under treatment, effectively diselectrify the substrate under treatment, namely remove electrons which are present on the substrate under treatment radiated with an electron beam, and improve the yield of substrates under treatment.

These and other objects, features and advantages of the present invention will become more apparent in light of the following detailed description of best mode embodiments thereof, as illustrated in the accompanying drawings.

### Brief Description of Drawings

Fig. 1 is a schematic plan view showing the structure of a substrate treatment apparatus according to an embodiment of the present invention;
Fig. 2 is an schematic perspective view describing the structure of an atmospheric aligner shown in Fig. 1;
Fig. 3 is a schematic perspective view describing the structure of a heat treatment section shown in Fig. 2;
Fig. 4 is a schematic sectional view describing the structure of the heat treatment section shown in Fig. 2;
Fig. 5 is a schematic sectional view describing the structure of the atmospheric aligner shown in Fig. 2;
Fig. 6 is a schematic plan view describing the structure of a vacuum preparation chamber shown in Fig. 1;
Fig. 7 is a schematic sectional view describing the structure of a reduced pressure transferring chamber shown in Fig. 1;
Fig. 8 is a schematic plan view describing the structure of an exposure treatment section shown in Fig. 1;
Fig. 9 is a flow chart describing a treatment flow with respect to the structure of the substrate treatment apparatus shown in Fig. 1;
Fig. 10 is a schematic sectional view describing the structure of the exposure treatment chamber shown in Fig. 1;
Fig. 11 is a schematic sectional view describing the structure of principal portions of the exposure treatment chamber shown in Fig. 10;
Fig. 12 is a schematic sectional view describing the structure of principal portions of the exposure treatment chamber shown in Fig. 10;
Fig. 13 is a schematic plan view describing the structure of a principal portions of a stage shown in Fig. 12;
Fig. 14 is a schematic diagram describing the structure of an electrostatic chuck mechanism section of the exposure treatment chamber shown in Fig. 10;
Fig. 15 is a schematic sectional view describing the structure of films of a substrate under treatment with respect to the electrostatic chuck mechanism section shown in Fig. 14;
Fig. 16 is a schematic sectional view describing the structure of films of a substrate under treatment with respect to the electrostatic chuck mechanism section shown in Fig. 14;
Fig. 17 is a schematic sectional view describing the structure of films of a substrate under treatment with respect to the electrostatic chuck mechanism section shown in Fig. 14;
Fig. 18 is a schematic diagram describing the structure of principal portions of a grounding mechanism of the electrostatic chuck mechanism section shown in Fig. 14;
Fig. 19 is a schematic plan view describing the structure of chuck electrodes of the electrostatic chuck mechanism section shown in Fig. 14;
Fig. 20 is a schematic plan view describing the structure of chuck electrodes of the electrostatic chuck mechanism section shown in Fig. 14;
Fig. 21 is a schematic plan view describing the structure of chuck electrodes of the electrostatic chuck mechanism section shown in Fig. 14;
Fig. 22 is a schematic plan view describing the structure of chuck electrodes of the electrostatic chuck mechanism section shown in Fig. 14;
Fig. 23 is a schematic plan view describing the structure of the substrate treatment apparatus shown in Fig. 1;
Fig. 24 is a schematic sectional view describing the structure of the substrate treatment apparatus shown in Fig. 1;
Fig. 25 is a schematic sectional view describing the structure of the substrate treatment apparatus shown in Fig. 1;
Fig. 26 is a schematic perspective view describing the structure of the substrate treatment apparatus shown in Fig. 1;
Fig. 27 is a schematic plan view describing the structure of the substrate treatment apparatus shown in Fig. 1;
Fig. 28 is a schematic diagram describing the structure of a control system of the substrate treatment apparatus shown in Fig. 1;
Fig. 29 is an outlined flow chart describing steps of the operation of the chuck electrodes of the electrostatic chuck mechanism section shown in Fig. 14;
Fig. 30 is an outlined flow chart describing steps of the operation of the chuck electrodes of the electrostatic chuck mechanism section shown in Fig. 14;
Fig. 31 is an outlined flow chart describing steps of the operation of the chuck electrodes of the electrostatic chuck mechanism section shown in Fig. 14;
Fig. 32 is an outlined flow chart describing steps of the operation of the chuck electrodes of the electrostatic chuck mechanism section shown in Fig. 14;
Fig. 33 is a schematic plan view showing the structure of a substrate treatment apparatus according to another embodiment of the present invention;
Fig. 34 is a schematic sectional view showing the structure of the substrate treatment apparatus with respect to a reduced pressure transferring chamber shown in Fig. 33;
Fig. 35 is an outlined plan view showing the structure of the substrate treatment apparatus with respect to the reduced pressure transferring chamber and an exposure treatment chamber shown in Fig. 33;
Fig. 36 is a schematic plan view showing the structure of the substrate treatment apparatus according to another embodiment of the present invention;
Fig. 37 is a schematic plan view showing the structure of Helmholtz coils shown in Fig. 36;
Fig. 38 is a schematic sectional view describing the structure of a vacuum preparation chamber and a reduced pressure-transferring chamber according to another embodiment of the present invention;
Fig. 39 is a schematic diagram describing the variation of pressures in the vacuum preparation chamber and the reduced pressure-transferring chamber shown in Fig. 38;
Fig. 40 is a schematic sectional view describing the structure of a seal of the exposure treatment chamber shown in Fig. 10;
Fig. 41 is a schematic plan view describing the structure of a system shown in Fig. 1 according to another embodiment of the present invention; and
Fig. 42 is a schematic plan view showing principal portions of the structure of the system shown in Fig. 41.

### Description of Preferred Embodiments

Next, with reference to the accompanying drawings, embodiments of the present invention will be described.

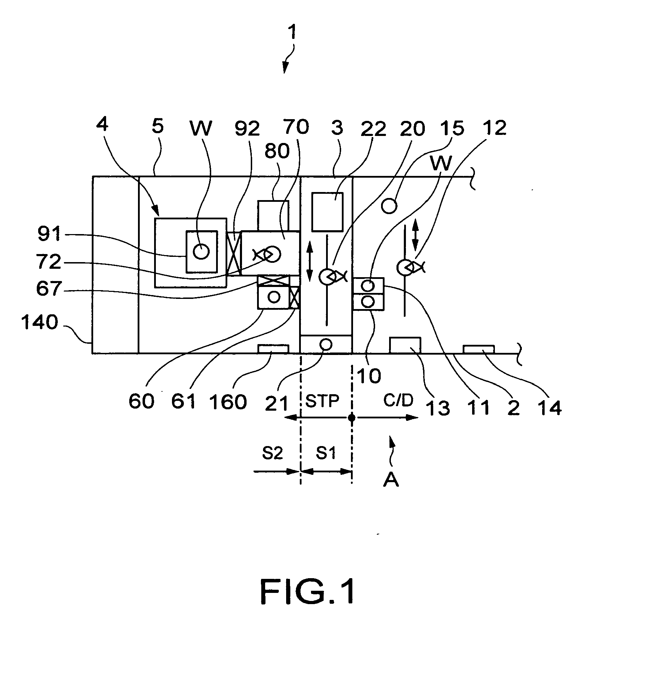

Fig. 1 is a schematic diagram showing the structure of a system of for example an exposing device as a substrate treatment apparatus according to an embodiment of the present invention. The system of the exposing device designated as reference numeral 1 can be freely inline connected to another device, for example a resist treatment device 2 (on a C/D side of Fig. 1). The resist treatment device 2 has a coating device that coats resist solution on a treatment surface of a substrate under treatment, for example a semiconductor wafer W (the coating device is referred to as a coater (COT)) and a developing device that develops a resist film formed on the treatment surface of the semiconductor wafer W (the developing device is referred to as a developer (DEV)). The exposing device 1 is made up of an atmospheric aligner section 3 (designated as S1 in Fig. 1) as a first unit (an interface section) having a linear space section and an exposure treatment section 5 (designated as S2 in Fig. 1) as a second unit. The atmospheric aligner section 3 conveys a semiconductor wafer W in atmospheric pressure (non-reduced pressure). The exposure treatment section 5 conveys a semiconductor wafer W in reduced pressure (non-atmospheric pressure) and performs an exposing treatment for the semiconductor wafer W.

Disposed on the resist treatment device 2 side are a passing portion 10, a receiving portion 11, and a conveying mechanism 12. The passing portion 10 has a stage with an alignment mechanism (not shown) that physically holds and aligns a semiconductor wafer W to be passed to the exposing device 1. The receiving portion 11 has a stage with an alignment mechanism (not shown) that physically holds and aligns a semiconductor wafer W received from the exposing device 1. The conveying mechanism 12 is of a self-propelled type and freely conveys a semiconductor wafer W to the passing portion 10 and the receiving portion 11.

Disposed on the resist treatment device 2 side are also a cassette section 13 and an operation panel 14 that face an operator's working space area A. The cassette section 13 can hold at least one holding member for example a cassette that can contain a plurality of semiconductor wafers W that are loaded and unloaded by the conveying mechanism 12. The operation panel 14 is an operation mechanism with a display mechanism for a control mechanism that controls the resist treatment device 2 side.

Disposed on the resist treatment device 2 side is also an alignment mechanism 15 that faces the operator's working space area A side (non-working space area side). The alignment mechanism 15 aligns a semiconductor wafer W to be transferred to the passing portion 10 and/or a semiconductor wafer W received from the receiving portion 11 with reference to a cutout portion for example a notch portion or an orientation flag portion thereof. The conveying mechanism 12 can freely load and unload a semiconductor wafer W to and from the alignment mechanism 15.

Disposed in the atmospheric aligner section 3 (designated as S1 in Fig. 1) are a self-propelled conveying mechanism 20 and an alignment mechanism 21. The self-propelled conveying mechanism 20 can freely convey a semiconductor wafer W to the passing portion 10 and the receiving portion 11 disposed on the resist treatment device 2 side. The alignment mechanism 21 is disposed on the working space area A side (on one end side in the longitudinal directions of the atmospheric aligner section 3). The alignment mechanism 21 aligns a semiconductor wafer W that has been received from the passing portion 10 on the resist treatment device 2 side and/or a semiconductor wafer W to be transferred to the receiving portion 11 on the resist treatment device 2 side with reference to a cutout portion, for example a notch portion or an orientation flat portion thereof. The self-propelled conveying mechanism 20 can freely load and unload a semiconductor wafer W to and from the alignment mechanism 21.

The alignment accuracy of the alignment mechanism 21 is important to improve the yield of semiconductor wafers W in the exposure treatment. Thus, the alignment mechanism 21 has higher alignment accuracy than does the alignment mechanism 15 on the resist treatment device 2 side and/or the passing portion 10 or the receiving portion 11 on the resist treatment device 2 side.

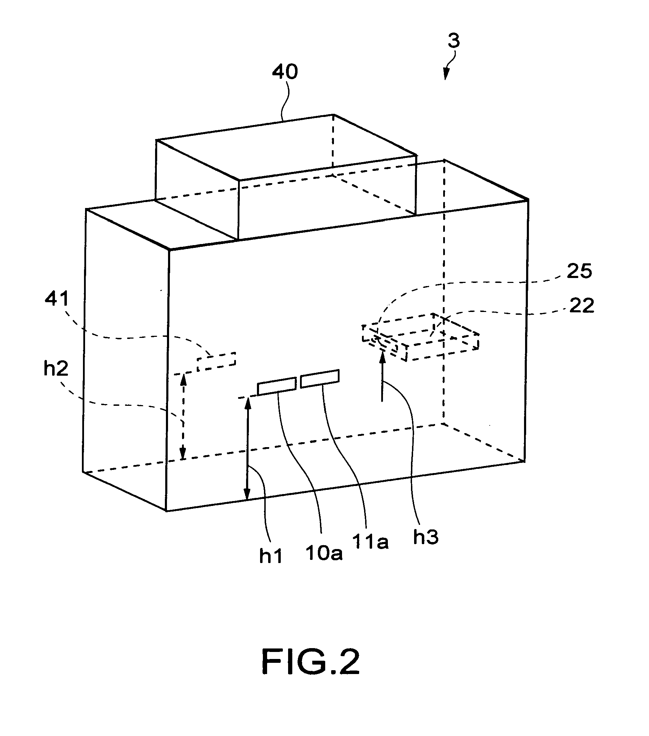

Disposed in the atmospheric aligner section 3 (designated as S1 in Fig. 1) is also a heat treatment section 22 that performs a Post Exposure Bake (PEB) treatment as a heat treatment for a semiconductor wafer W that has been exposed in the exposure treatment section 5. The heat treatment section 22 faces the working space area A side of the self-propelled conveying mechanism 20 (on the other end side in the longitudinal directions of the atmospheric aligner section 3) as shown in Fig. 2, Fig. 3, and Fig. 4.

The heat treatment section 22 has a loading/unloading opening 25 through which a semiconductor wafer W is loaded and unloaded to and from the heat treatment section 22. The heat treatment section 22 contains a heating plate 26 as a heat treatment mechanism and a temperature adjustment plate 27 as a temperature adjustment mechanism. The heating plate 26 has a heating mechanism, for example a heater 31, that generates predetermined heat, for example in the range from 75 °C to 650 °C, preferably for example in the range from 120 °C to 300 °C, more preferably for example 250 °C for a semiconductor wafer W. The temperature adjustment plate 27 is a temperature adjustment mechanism that adjusts the temperature of a semiconductor wafer W to a predetermined temperature, for example 23 °C that is nearly the same as the inner temperature of the atmospheric aligner section 3 or the inner temperature of the resist treatment device 2.

Of course, the temperature adjustment plate 27 adjusts the temperature of a semiconductor wafer W before and after it is conveyed to the heating plate 26. Instead, the temperature adjustment plate 27 may adjust the temperature of a semiconductor wafer W received from the passing portion 10 on the resist treatment device 2 side by the self-propelled conveying mechanism 20 and/or a semiconductor wafer W to be conveyed to the receiving portion 11 of the resist treatment device 2 by the self-propelled conveying mechanism 20 without conveying the semiconductor wafer W to the heating plate 26. The temperature adjustment plate 27 may adjust the temperature of a semiconductor wafer W before and/or after it is conveyed to the alignment mechanism 21.

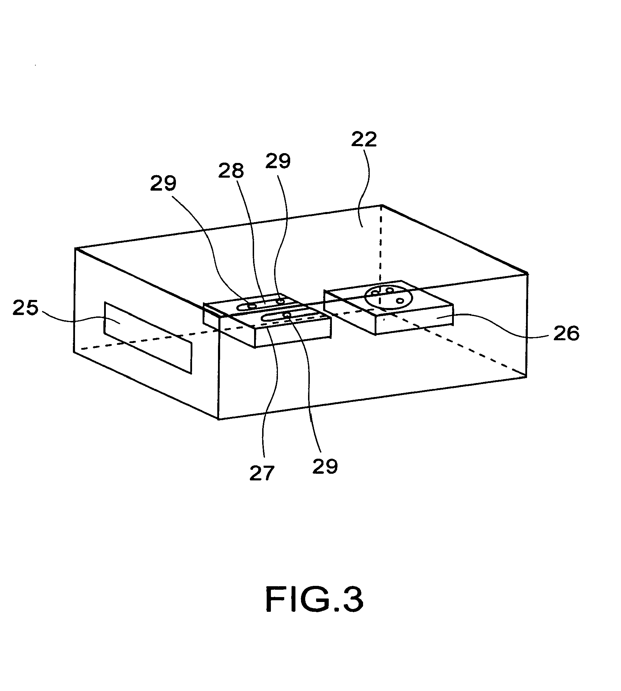

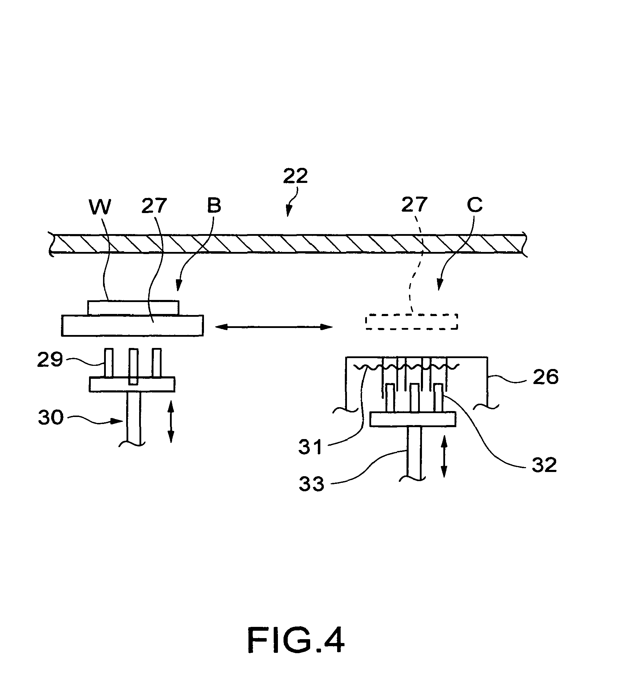

As shown in Fig. 3 and Fig. 4, the temperature adjustment plate 27 can be horizontally moved between a standby position B and an upper position B of the heating plate 26 by a moving mechanism (not shown). A support mechanism 30 is disposed below the temperature adjustment plate 27 and at the standby position B of the temperature adjustment plate 27. The support mechanism 30 has a plurality of support pins, for example three support pins, that protrude from cutout portions 28 of the temperature adjustment plate 27 and point-support the rear surface of the semiconductor wafer W.

In addition, the heating plate 26 has a support mechanism 33 with a plurality of support pins, for example three support pins, that raise and lower and point-support the rear surface of a semiconductor wafer W. Thus, a semiconductor wafer W conveyed by the self-propelled conveying mechanism 20 through the loading/unloading opening 25 is received at the up position of the support mechanism 30. The semiconductor wafer W is supported by the support pins 29. Thereafter, when the support mechanism 30 is lowered, the semiconductor wafer W on the support points 29 is transferred to the temperature adjustment plate 27. After the temperature adjustment plate 27 is raised to the up position of the heat treatment section 22, the support mechanism 33 is raised. The semiconductor wafer W on the temperature adjustment plate 27 is supported on the support pins 32. When or after the temperature adjustment plate 27 is moved to the standby position, the support mechanism 33 is lowered and the semiconductor wafer W is transferred to the heating plate 26.

As shown in Fig. 2, a fan filter unit (FFU) 40 is disposed above the atmospheric aligner section 3 (designated as S1 in Fig. 1). The FFU 40 generates a down-flow of clean air in the atmospheric aligner section 3. The temperature, the humidity, and/or concentration of a chemical compound, for example amine, of the clean air are controlled. The concentration of amine is controlled to a predetermined value for example 1 ppb or less by a filter mechanism (not shown). In addition, the inner pressure of the atmospheric aligner section 3 is controlled to a predetermined value.

Next, a conceptual example of suppressing occurrence of cross contamination in the atmospheric aligner section 3 (designated as S1 in Fig. 1) will be described. Now, the height of each of a loading opening 10a for a semiconductor wafer W from the passing portion 10 on the resist treatment device 2 side and a unloading opening 11a for a semiconductor wafer W to the receiving portion 11 on the resist treatment device 2 side is designated as h1. The height of a loading/unloading opening 41 for a semiconductor wafer W on the exposure treatment section 5 side is designated as h2. The height of a loading/unloading opening 25 for a semiconductor wafer W loaded and unloaded to and from the heat treatment section 22 is designated as h3. Since the exposure treatment section 5 is operated in reduced pressure and the air cleanness class required in the exposure treatment is higher than that for the environment in the resist treatment device 2, the condition of h2 ≥ h1 is kept, preferably h2 > h1. In addition, from a point of view of suppressing the influence of heat from the loading/unloading opening 25 of the heat treatment section 22, the condition of h3 ≥ (h1 or h2) is kept, preferably h3 > (h1 or h2).

When the height of the loading opening 10a and/or the unloading opening 11a and the height of the loading/unloading opening 41 are nearly the same, it is preferred that they not just face each other, but with a slight deviation.

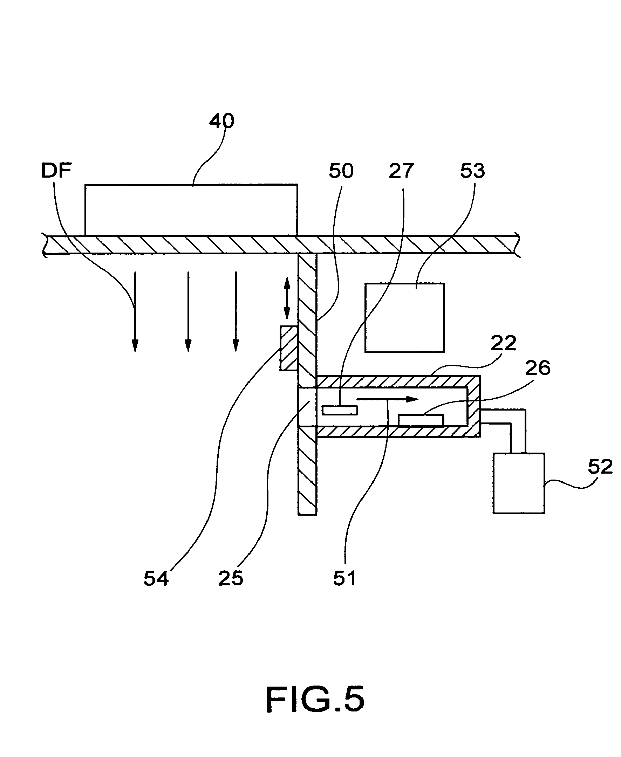

Next, another conceptual example of suppression of influence of heat from the loading/unloading opening 25 of the heat treatment section 22 will be described with reference to Fig. 5. A wall 50 is disposed above and below the loading/unloading opening 25 through which a semiconductor wafer W is loaded to and from the heat treatment section 22. The wall 50 shields inner atmosphere of the heat treatment section 22 from inner atmosphere of the self-propelled conveying mechanism 20. A venting mechanism, for example a vacuum pump 52, generates an air flow 51 in the heat treatment section 22 so that the air flow 51 occurs from the temperature adjustment plate 27 side to the heating plate 26 side.

With an opening and closing mechanism 54 that can open and close an opening portion of the loading/unloading opening 25, radiation of heat can be suppressed. With this structure, an area for a down-flow DF in the atmospheric aligner section 3 can be decreased. As a result, the FFU 40 can be downsized. As the merits, the system can be downsized and the foot print and cost of the apparatus can be decreased. When a control mechanism 53 (and/or a heat generation mechanism such as a power supply mechanism) of the heat treatment section 22 is disposed above the heat treatment section 22, the influence of heat to a semiconductor wafer W in the atmospheric aligner section 3 can be suppressed.

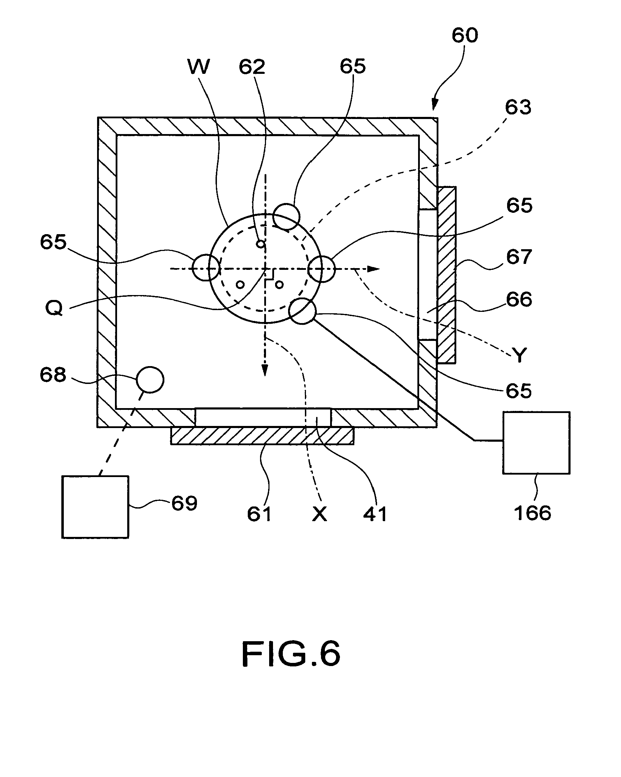

As shown in Fig. 6, a vacuum preparation chamber 60 is disposed in the exposure treatment section 5. The vacuum preparation chamber 60 is a substrate loading and unloading section through which a semiconductor wafer W is loaded and unloaded by the self-propelled conveying mechanism 20 through the loading/unloading opening 41. Disposed at the loading/unloading opening 41 of the vacuum preparation chamber 60 is an opening and closing mechanism 61 that air-tightly seals the interior of the vacuum preparation chamber 60. The vacuum preparation chamber 60 has a holding table 63 with a support mechanism (not shown). The support mechanism has a plurality of support pins 62 for example three support pins 62 that point-support the bottom surface of a semiconductor wafer W that can be freely transferred by the self-propelled conveying mechanism 20.

In addition, the holding table 63 has a temperature adjustment mechanism (not shown). The temperature adjustment mechanism adjusts the temperature of the holding table 63 to a temperature lower than the temperatures of sections of the resist treatment device 2, for example the temperature of a semiconductor wafer W treated by the coating device (coater COT) that coats resist solution on the semiconductor wafer W, the ambient temperature in the resist treatment device 2, and/or the ambient temperature in the atmospheric aligner section 3, for example in the range from a fraction of 1 °C to 3 °C , preferably in the range from 0.1 °C to 0.5 °C. As a result, the accuracy of the exposure treatment can be prevented from deteriorating since a resist film formed on a semiconductor wafer W can be prevented from shrinking and expanding.

In addition, at least one image detection mechanism is disposed at an upper position of a semiconductor wafer W held on the holding table 63. For example, a plurality of CCD cameras 65 are disposed so that an image of at least a peripheral portion of a semiconductor wafer W can be freely detected. These CCD cameras 65 are disposed to detect at least an arrangement angle θ of a semiconductor wafer W. The CCD cameras 65 are disposed in such a manner that at least one CCD camera 65, preferably two CCD cameras 65, are disposed on the Y-axis perpendicular to the conveying directions of a semiconductor wafer W by the self-propelled conveying mechanism 20, namely on the X-axis and at least one CCD camera 65 is disposed with an angle on the Y-axis. Thus, based on the arrangement angle θ and reference coordinates pre-registered on the X and Y-axes, namely registered data and detected data are compared. The difference is calculated and detected by a control mechanism 166. In Fig. 6, Q denotes the center position of a semiconductor wafer W.

In addition, a conveying opening 66 is disposed in the directions on the Y-axis of the vacuum preparation chamber 60. A semiconductor wafer W is conveyed to a reduced pressure-conveying chamber (that will be described later) through the conveying opening 66. An opening and closing mechanism 67 that can air-tightly close the conveying opening 66 is disposed in the conveying opening 66. The vacuum preparation chamber 60 has an air-venting nozzle 68 through which a venting mechanism, for example an exhaust pump 69, vents the vacuum preparation chamber 60. Thus, the supply amount of a predetermined gas, for example inert gas such as nitrogen gas, supplied from a gas supplying mechanism (not shown) and the amount of gas vented of the exhaust pump 69 can be freely set between a predetermined degree of vacuum and atmospheric pressure under the control of the control mechanism 166.

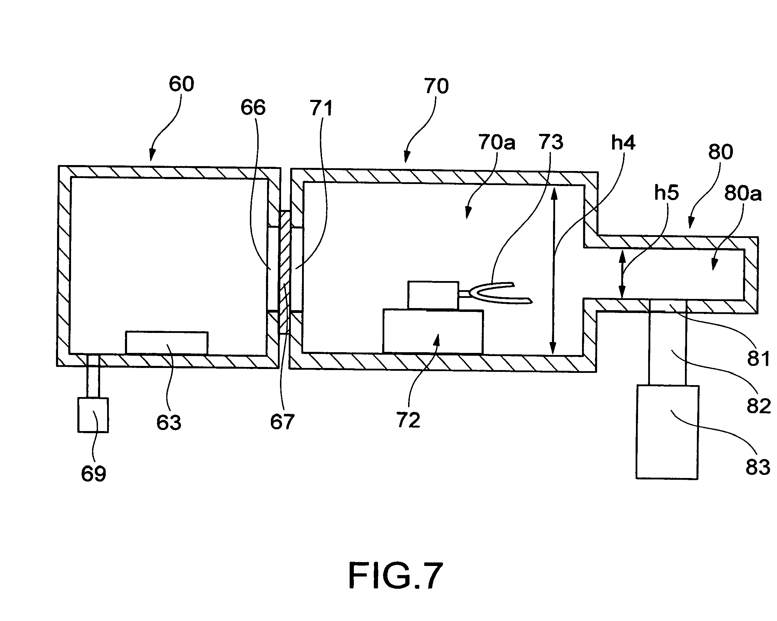

Next, with reference to Fig. 1 and Fig. 7, the reduced pressure conveying chamber 70 will be described. Disposed in the reduced pressure conveying chamber 70 is a conveying mechanism 72 that conveys a semiconductor wafer W to the vacuum preparation chamber 60 through a conveying opening 71. The conveying mechanism 72 has an arm 73 that is a support mechanism having a surface contact function of at least one position of the peripheral portion of a semiconductor wafer W and/or a point contact function of a plurality of points on the rear surface of the semiconductor wafer W.

Disposed in the reduced pressure conveying chamber 70 is an gas venting chamber 80 opposite to the vacuum preparation chamber 60 of the reduced pressure conveying chamber 70. The gas venting chamber 80 is connected to the atmosphere of the reduced pressure conveying chamber 70. An air venting nozzle 81 is disposed below the gas venting chamber 80. A venting mechanism, for example a vacuum pump 83, vents not only the gas venting chamber 80 but the reduced pressure conveying chamber 70 from the air venting nozzle 81 through an air venting path 82.

Thus, a venting mechanism is not directly connected to the reduced pressure conveying chamber 70. Since the conveying mechanism 72 is disposed in the reduced pressure conveying chamber 70 and the venting mechanism is connected thereto, a problem of which the reduced pressure conveying chamber 70 becomes large is solved. Thus, the apparatus can be downsized and slimmed. In addition, even if the vacuum pump 83 and so forth get defective or the air venting path 82 is maintained, when the gas venting chamber 80 is removably structured, the maintenance time can be short. With respect to the relationship of a volume 70a of the reduced pressure conveying chamber 70 and a volume 80a of the gas venting chamber 80, the condition of volume 70a ≥ volume 80a is kept, more preferably volume 70a > volume 80a. Thus, the throughput of which the reduced pressure conveying chamber 70 is maintained in a predetermined degree of vacuum is improved. In addition, the height h4 of the space section of the reduced pressure conveying chamber 70 is greater than the height h5 of the space section of the gas venting chamber 80. As a result, the gas venting chamber 80 can be vented at high venting speed.

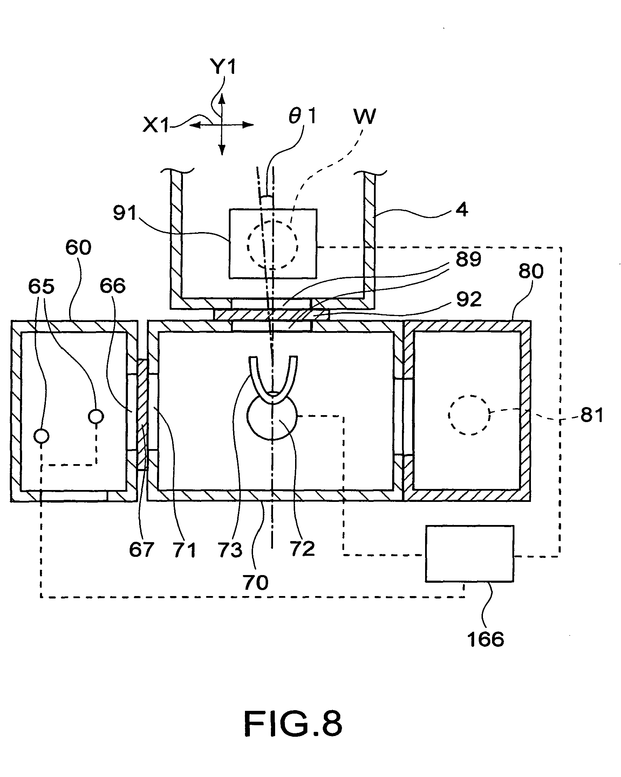

In addition, as shown in Fig. 8, the conveying mechanism 72 of the reduced pressure conveying chamber 70 is controlled by the control mechanism 166. When there is an error as a result of a calculation based on data captured by the CCD cameras 65, a conveying angle θ1 of the arm 73 for a semiconductor wafer W held by the arm 73 to an exposure treatment chamber 4 is varied and compensated (the position is adjusted by a rotation operation of the arm 73) based on information of the error. The semiconductor wafer W held by the arm 73 is conveyed through a loading opening 89 to a stage 91 of the exposure treatment chamber 4 in which reduced pressure is maintained. In other words, the semiconductor wafer W is aligned and compensated on the stage 91. The loading opening 89 of the reduced pressure conveying chamber 70 and the loading opening 89 of the exposure treatment chamber 4 can be air-tightly opened and closed.

In addition, the stage 91 in the exposure treatment chamber 4 can freely move a semiconductor wafer W in directions on the X1 axis (left and right directions shown in Fig. 8) and directions on the Y1 axis (upper and lower directions shown in Fig. 8). When there is an error as a result of a calculation based on data captured by the CCD cameras 65, the control mechanism 166 horizontally aligns the semiconductor wafer W held on the stage 91 with respect to the X and Y-axes based on the information about the error. When the semiconductor wafer W is conveyed by varying the conveying angle θ1 of the arm 73 to the exposure treatment chamber 4, the stage 91 of the exposure treatment chamber 4 is moved based on data of which the transfer position of the semiconductor wafer W by the arm 73 is predicted by the control mechanism 166.

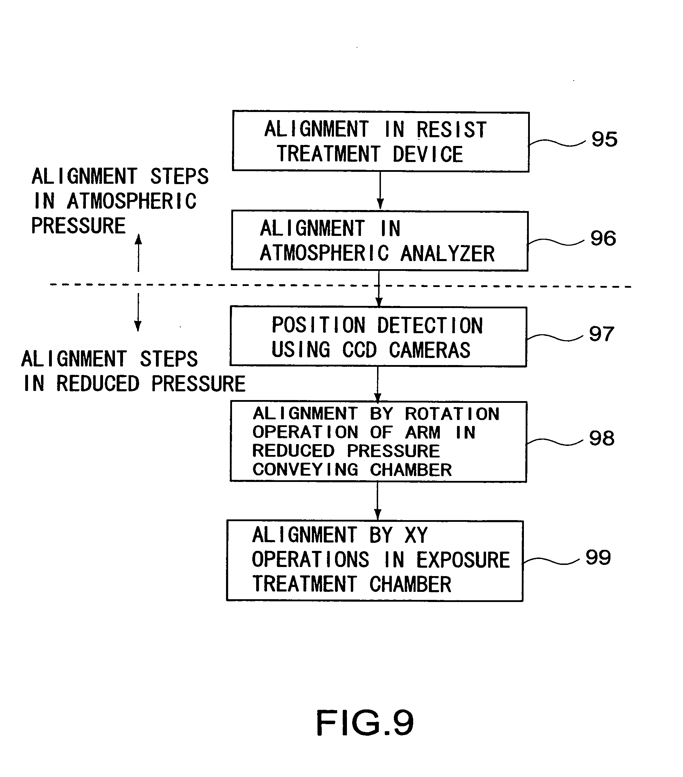

Thus, the semiconductor wafer W is aligned at steps shown in Fig. 9. At step 95, the semiconductor wafer W is aligned on the resist treatment device 2 side as another device. At step 96, the semiconductor wafer W is aligned in the atmospheric aligner section 3. At these steps, the semiconductor wafer W is aligned in atmospheric pressure. Thereafter, at step 97, the position of the semiconductor wafer W is detected by the CCD cameras 65 of the vacuum preparation chamber 60 in reduced pressure. At step 98, while the rotation angle of the arm 73 of the reduced pressure conveying chamber 70 is being adjusted based on position data detected by the CCD cameras 65, the semiconductor wafer W held by the arm 73 is aligned in reduced pressure. Thereafter, at step 99, while the stage 91 of the exposure treatment chamber 4 as another reduced pressure chamber is being moved on the X and Y-axes, the semiconductor wafer W on the stage 91 is aligned in reduced pressure. The semiconductor wafer W is aligned at a plurality of positions in atmospheric pressure. Thereafter, the position of the semiconductor wafer W is detected in reduced pressure. In addition, the semiconductor wafer W is aligned at a plurality of positions in reduced pressure. Thus, the accuracy with which the semiconductor wafer W is aligned is improved.

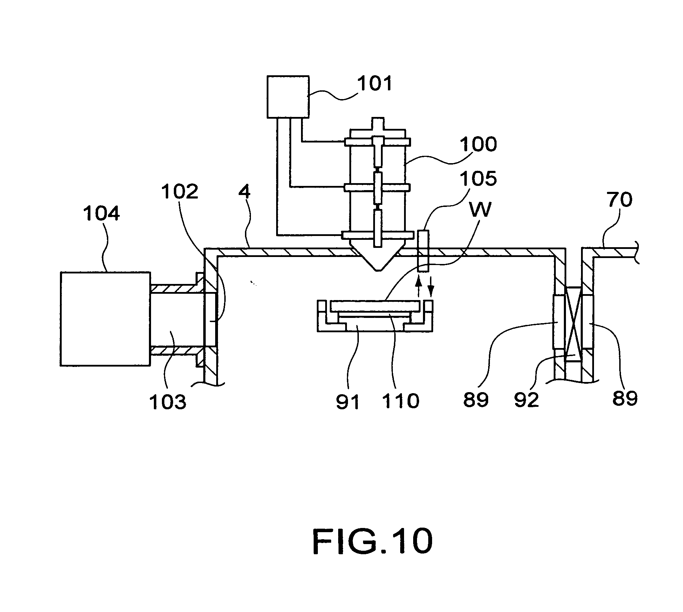

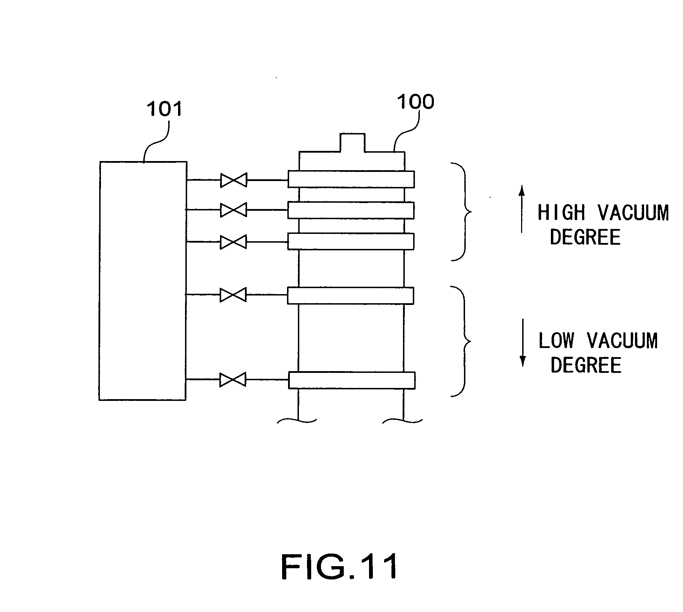

As shown in Fig. 10, the exposure treatment chamber 4 has a column 100 at a ceiling portion. The column 100 is an electron beam radiating mechanism that radiates a semiconductor wafer W on the stage 91 with an electron beam. The column 100 has an electron gun that is an electron beam generation source and a venting mechanism, for example an ion pump 101, that highly vacuum-vent the electron gun section. The column 100 has a plurality of air venting lines at a plurality of vertical positions thereof as shown in Fig. 11. The column 100 is vented through the air venting lines so that a predetermined degree of vacuum is achieved. Thus, substantially, the higher position the column 100, the higher the degree of vacuum, namely the lower position the column 100, the lower the degree of vacuum. This structure allows the linearity of an electron beam to improve or prevents energy of the electron beam from decreasing. The higher the position of the column 100, the larger the intervals of the air venting paths; the lower the position of the column 100, the smaller the intervals of the air venting paths.

In addition, as shown in Fig. 10, the exposure treatment chamber 4 has an air venting duct 102 in a side wall opposite to the reduced pressure conveying chamber 70 of the stage 91. A venting mechanism, for example, a high vacuum pump (turbo molecular pump) 104 that vents the inside of the exposure treatment chamber 4 through an air venting line 103 is disposed. Disposed at a ceiling section of the exposure treatment chamber 4 is also a mark detection mechanism 105 that optically detects a mark formed on the treatment surface of a semiconductor wafer W held on the stage 91. When necessary, the semiconductor wafer W is finally aligned by moving the stage 91 on the X and Y-axes based on the detected mark. When the mark detection mechanism 105 moves the stage 91 on the X and Y-axes and aligns the semiconductor wafer W with a plurality of marks on chips formed on the treatment surface of the semiconductor wafer W, the control mechanism 166 causes the mark detection mechanism 105 to detect the marks in the order according to a predetermined algorithm, for example the traveling salesman problem (TSP), so as to shorten the traveling distance (time) of the stage 91 and improve the throughput of the aligning process.

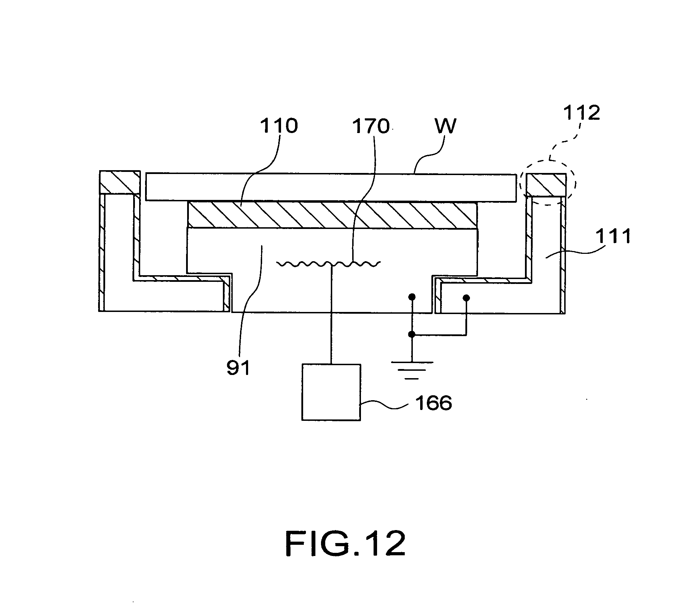

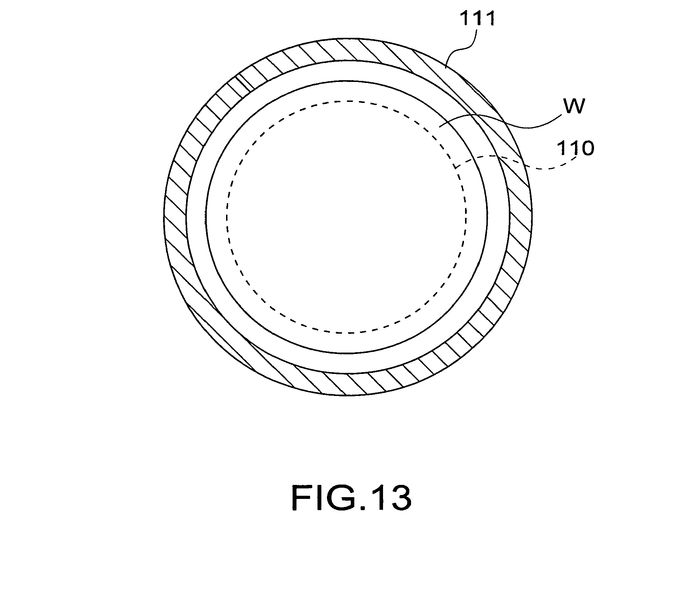

As shown in Fig. 12 and Fig. 13, the stage 91 has an electrostatic chuck mechanism 110 that electrostatically sucks and holds a semiconductor wafer W. The stage 91 is made of an insulation material, for example alumina. The front surface of the stage 91 is coated with a conductive film because of the following reasons.
1) Light, strong, non-stretchable material: The weight of the movable portion of the stage can be decreased. The characteristic frequency can be raised. The thermal expansion can be decreased.
2) Decrease of disturbance to beam: When the front surface of the stage 91 is charged with electrons, they affect the path of an electron beam. Thus, the whole surface exposed to the beam is conductively formed so that electrons flow to the ground. If the conductive material were thick, an eddy current would occur, adversely affecting the beam. Thus, it is preferred that the conductive portion of the front surface of the stage 91 be thinly formed.

In addition, a ring-shaped member 111 is disposed around the stage 91. The ring-shaped member 111 is made of an insulation material, for example alumina. The front surface of the ring-shaped member 111 is coated with a conductive film. The outer peripheral portion of the ring-shaped member 111 has a flat portion 112 whose height is the same as the height of the treatment surface of a semiconductor wafer W sucked and held by the electrostatic chuck mechanism 110 of the stage 91. In addition, the flat portion 112 is level with the semiconductor wafer W. The front surface of the ring-shaped member 111 is coated with an electron beam refraction protection film as an eddy current protection mechanism that suppresses the refraction of an electron beam emitted from a column 100, namely occurrence of an eddy current. The film is made of for example titan such as a TiN film. In addition, the ring-shaped member 111 and the stage 91 are grounded as shown in Fig. 12.

In addition, as shown in Fig. 12 and Fig. 13, the stage 91 has an electrostatic chuck mechanism 110 as an electrostatic chuck mechanism that electrostatically sucks and holds a semiconductor wafer W. The stage 91 is made of a conductive material, for example alumina. The ring-shaped member 111 is disposed around the stage 91. The ring-shaped member 111 is made of a conductive material, for example alumina. The ring-shaped member 111 has a flat portion 112. The height of the outer peripheral portion of the flat portion 112 is almost the same as the height of the treatment surface of the semiconductor wafer W sucked and held by the electrostatic chuck mechanism 110 of the stage 91. The front surface of the ring-shaped member 111 is coated with an electron beam refraction protection film that suppresses the refraction of an electron beam emitted from the column 100, namely occurrence of an eddy current. The film is made of for example titan such as a TiN film. In addition, as shown in Fig. 12, the ring-shaped member 111 and the stage 91 are grounded.

In addition, the stage 91 has a heating mechanism, for example a heater 170. The control mechanism 166 can freely adjust the temperature of the semiconductor wafer W on the stage 91 to a predetermined temperature along with a cooling mechanism (not shown). The predetermined temperature is lower than the temperature of a semiconductor wafer W in a treatment section of the resist treatment device 2, for example, the coating device (coater (COT)), that coats resist solution on the semiconductor wafer W, the inner temperature of the resist treatment device 2, and/or the inner temperature of the atmospheric aligner section 3. The predetermined temperature is for example a low temperature in the range from a fraction of 1 °C to 3 °C, preferably in the range from 0.1 °C to 0.5 °C. In other words, the accuracy of the exposure treatment can be prevented from deteriorating against expansion or shrinkage of the resist film formed on the semiconductor wafer W. For example, when a load lock (for example, the vacuum preparation chamber 60) is vacuum-vented, since heat is removed from the semiconductor wafer W, the temperature of the semiconductor wafer W that has been just conveyed to the stage 91 tends to be lower than the temperature of the semiconductor wafer W in for example the atmospheric aligner section 3 before the semiconductor wafer W is conveyed to the load lock. Thus, when the temperature of the stage 91 is lowered for which the temperature of the semiconductor wafer W is lowered by vacuum venting, it is not necessary to wait until the temperature of the semiconductor wafer W conveyed to the stage becomes stable (namely, expansion of the semiconductor wafer W stops).

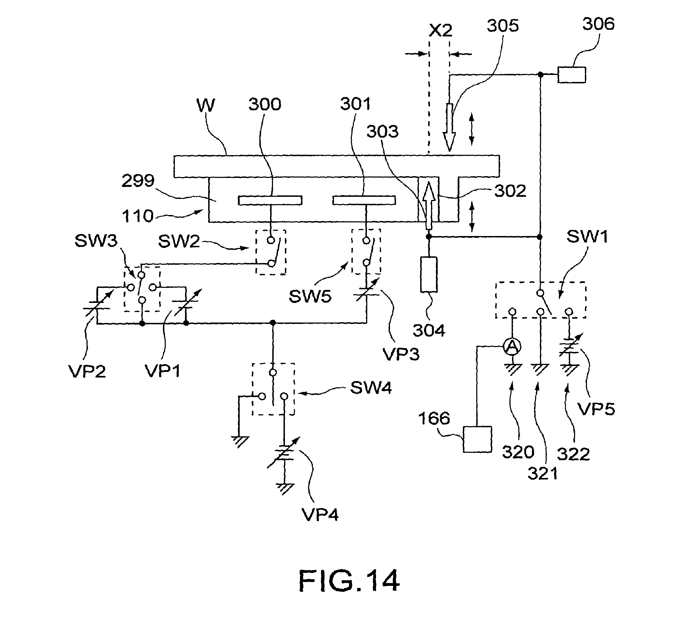

In addition, as shown in Fig. 14, the electrostatic chuck mechanism 110 has a plurality of electrodes, for example two electrodes, that are a first electrode 300 and a second electrode 301 buried in an insulation member 299 made of an insulator such as ceramics. A conductive needle 303 that is a conductive mechanism (grounding mechanism) is disposed outside the second electrode 301. The conductive needle 303 can be freely moved in a through-hole 302 formed in the insulation member 299 and contacted to a predetermined position on the rear surface of the semiconductor wafer W. In addition, a raising and lowering mechanism (first conductive needle contacting mechanism) 304 is disposed. The raising and lowering mechanism 304 raises and lowers the conductive needle 303 so that it contacts the rear surface of the semiconductor wafer W with a predetermined pressure.

In addition, a conductive needle 305 that is a conductive mechanism is disposed at a more outer peripheral position on the treatment surface of the semiconductor wafer W than the conductive needle 303 by a predetermined distance, for example X2 shown in Fig. 14. The conductive needle 305 can be contacted to a resist film area of the treatment surface of the semiconductor wafer W. In addition, a raising and lowering mechanism (second conductive needle contacting mechanism) 306 is disposed. The raising and lowering mechanism 306 raises and lowers the conductive needle 305 so that it contacts the treatment surface of the semiconductor wafer W with a predetermined pressure.

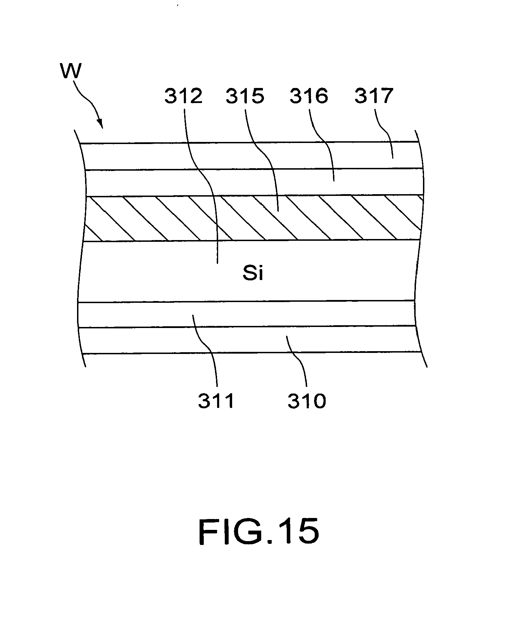

As shown in Fig. 15 (a sectional view showing a semiconductor wafer W), with respect to contacting of the conductive needle 303 and the conductive needle 305 to a semiconductor wafer W, the conductive needle 303 is pressed by the raising and lowering mechanism 304 so that the conductive needle 303 contacts at least a nitride film formed on the rear surface of the semiconductor wafer W, for example an SiN film 301, and an oxide film, for example a SiO₂ film 311 as a base film thereof. Thus, the raising and lowering mechanism 304 needs to have a pressing force that causes the conductive needle 303 to pierce the SiN film 310. Instead, the raising and lowering mechanism 304 may cause the conductive needle 303 to pierce a plurality of films for example SiN and SiO₂, and contact Si. A film that the conductive needle 303 and/or the conductive needle 305 contacts may be a compound made of the same material as the semiconductor wafer W, for example SiO₂, SiN, SiC, SiOC, SiF, or the like.

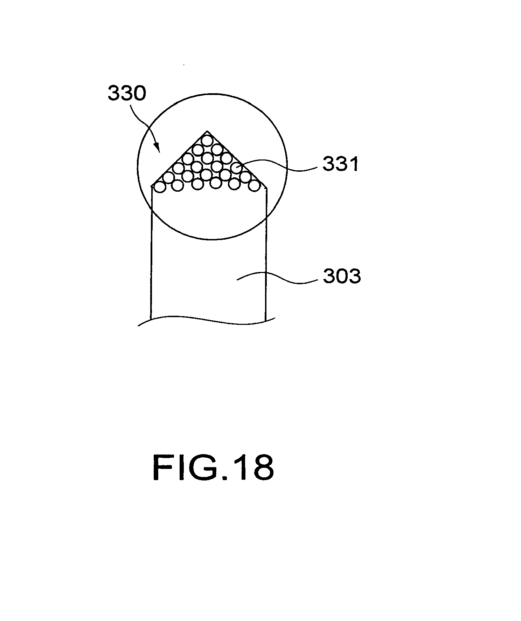

According to this embodiment, Si 312 is the material of the semiconductor wafer W itself. Thus, static electricity charged in the semiconductor wafer W can be effectively removed from the rear surface thereof by the conductive needle 303. In addition, since the conductive needle 303 does not reach Si 312, which is the material of the semiconductor wafer W itself, the problem of breakage and so forth of the semiconductor wafer W itself can be solved. On the other hand, since the conductive needle 303 needs to pierce the SiN film 310, which is a harder film than a film on the treatment surface side, as shown in Fig. 18, a conductive hard material, for example a plurality of pieces of a conductive diamond 331, are buried in a tip portion 330 of the conductive needle 303. The material of the tip portion 330 or the material of the conductive needle 303 may be tungsten carbide, alumina titanium carbide type ceramic (Al₂O₃ + TiC), thermite (TiC + TiN), tungsten, palladium, iridium, or beryllium-copper alloy besides conductive diamond. Important characteristics for the material of the conductive needles are (1) conductive, (2) hard, and (3) nonmagnetic.

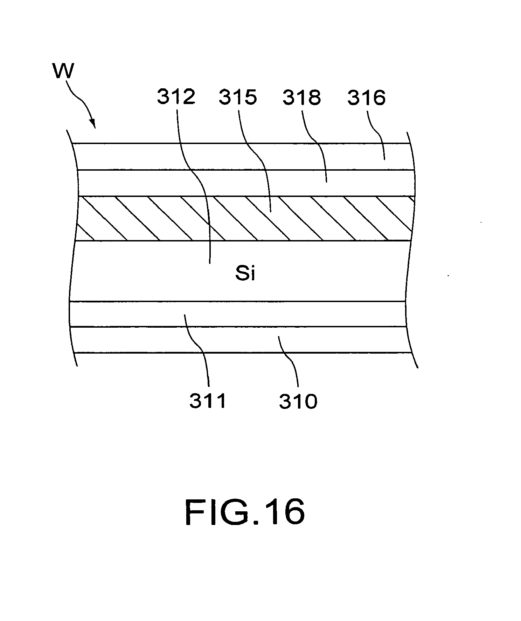

With respect to the contacting of the conductive needle 305 on the treatment surface side of the semiconductor wafer W, the conductive needle 305 is contacted to for example a circuit pattern area 315 formed on the treatment surface side of the semiconductor wafer W, a resist film 316 formed on the circuit pattern area 315, and an antistatic film 317 formed on the resist film 316. As another example, as shown in Fig. 16, the conductive needle 305 is contacted to the circuit pattern area 315 formed on the treatment surface side of the semiconductor wafer W, a conductive film 318 formed on the circuit pattern area 315, and the resist film 316 formed on the conductive film 318.

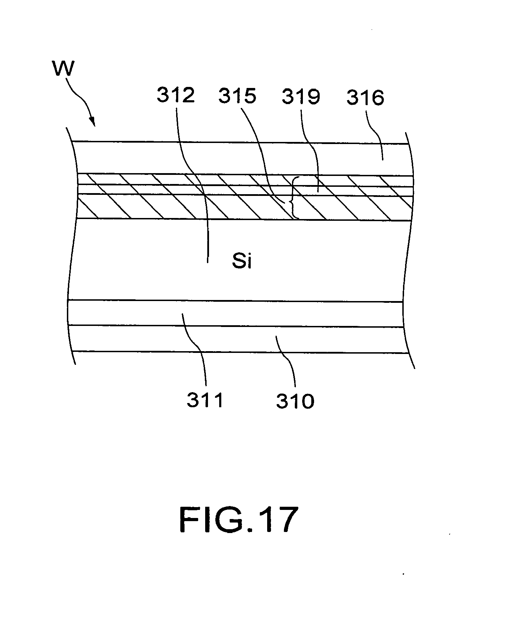

As another example shown in Fig. 17, the conductive needle 305 is contacted to the circuit pattern area 315 formed on the treatment surface side of the semiconductor wafer W, a conductive film 319 formed in the circuit pattern area 315, and the resist film 316 formed in the circuit pattern area 315.

Thus, the semiconductor wafer W is not directly contacted to Si 312 of the semiconductor wafer W itself. Instead, since the conductive needle 305 is contacted to a conductive film formed on Si 312 of the semiconductor wafer W itself, static electricity charged in the semiconductor wafer W can be effectively removed from the treatment surface side by the conductive needle 305. In addition, since the conductive needle 305 does not reach Si 312, which is the material of the semiconductor wafer W itself, the problem of breakage and so forth of the semiconductor wafer W itself can be solved.

In addition, since the conductive needle 305 does not reach Si 312, which is the material of the semiconductor wafer W itself, a contact hole of the conductive needle 305 formed in the circuit pattern area 315 and the resist film 316 can be decreased. Thus, the contacting of the conductive needle 303 and the conductive needle 305 does not largely affect the later treatments, for example coating of developing solution on the semiconductor wafer W in the developing treatment of the resist treatment device 2. As a result, the yield of semiconductor wafers W can be improved.

In addition, as shown in Fig. 14, the conductive needle 303 and the conductive needle 305 can be freely connected to a first switch terminal 320, a second switch terminal 321, or a third switch terminal 322 selected through a switch mechanism, for example a switch SW1. The first switch terminal 320 is connected to a current detection mechanism, for example an ammeter, that detects a current that flows in the conductive needle 303 and/or the conductive needle 305. The second switch terminal 321 is connected to the ground. Thus, the conductive needle 303 and/or the conductive needle 305 is grounded through the second switch terminal 321. The third switch terminal 322 is connected to a power supply VP5 that applies a predetermined voltage to the conductive needle 303 and/or the conductive needle 305.

The term "and/or" of the conductive needle 303 and/or the conductive needle 305 means that the conductive needle 303 and the conductive needle 305 are connected and also they are connected to the first switch terminal 320, the second switch terminal 321, or the third switch terminal 222. Instead, for each of the conductive needle 303 and the conductive needle 305, the first switch terminal 320, the second switch terminal 321, and the third switch terminal 322 may be independently provided.

In addition, data of a current value in the ammeter connected to the first switch terminal 320 can be monitored by the control mechanism 166. In addition, for convenience, in the power supply connected to the third switch terminal 322, a negative voltage is applied to the conductive needle 303 and the conductive needle 305. Instead, a positive voltage may be applied to the conductive needle 303 and the conductive needle 305. When necessary, the polarities of the voltages applied may be changed.

In addition, the first electrode 300 is connected to a switch mechanism, for example a switch SW2, and another switch mechanism, for example a switch SW3. The switch SW3 can freely connect the first electrode 300 to a power supply VP1 that applies a predetermined negative voltage thereto or a power supply VP2 that applies a predetermined positive voltage thereto. In addition, the power supply VP1 and the power supply VP2 can be freely connected to a power supply VP4 that generates a reference voltage through a switch mechanism, for example a switch SW4. The switch SW4 can freely select one of the power supply VP4 side and the GND side. Thus, when the switch SW4 selects the GND, the reference voltage becomes 0 V.

In addition, the second electrode 301 can be freely connected to a power supply VP3 that applies a predetermined negative voltage through a switch mechanism, for example a switch SW5. In addition, the power supply VP3 can be freely connected to the power supply VP4 that applies the reference voltage through a switch mechanism, for example the switch SW4. Likewise, the switch SW4 can freely select one of the power supply VP4 side and the GND side. Thus, when the switch SW4 selects the GND, the reference voltage becomes 0 V.

In the foregoing description, the power supply VP1 applies a predetermined negative voltage; the power supply VP2 applies a predetermined positive voltage; and the power supply VP3 applies a predetermined negative voltage. In contrast, the power supply VP1 may apply a predetermined positive voltage; the power supply VP2 may apply a predetermined negative voltage; and the power supply VP3 may apply a predetermined positive voltage. In the drawing, the power supply VP4 applies a negative reference voltage. Instead, the power supply VP4 may apply a positive reference voltage. When necessary, the polarities of the voltages applied may be changed.

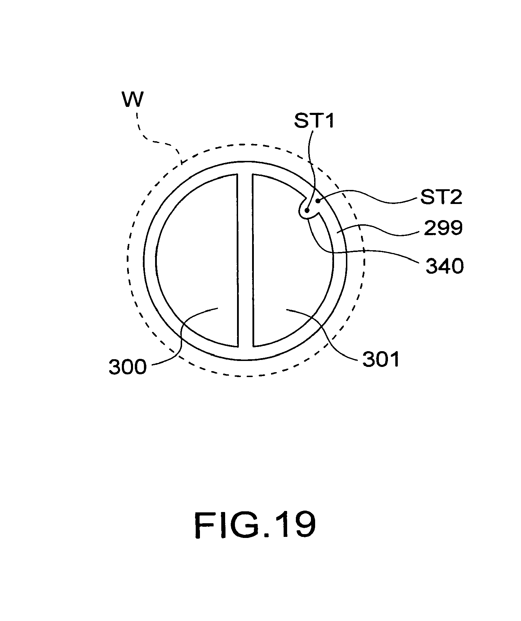

With respect to the shapes of the first electrode 300 and the second electrode 301, as shown in Fig. 19, Fig. 20, Fig. 21, and Fig. 22, there are many types of patterns. With respect to the shapes of the first electrode 300 and the second electrode 301 shown in Fig. 19, the first electrode 300 and the second electrode 301 are formed in a semi-circular shape. The insulation member 299 has a notch portion 340. In the notch portion 340, there are a contact position ST1 that the conductive needle 303 contacts on the rear surface of the semiconductor wafer W and a contact position ST2 that the conductive needle 305 contacts on the treatment surface of the semiconductor wafer W.

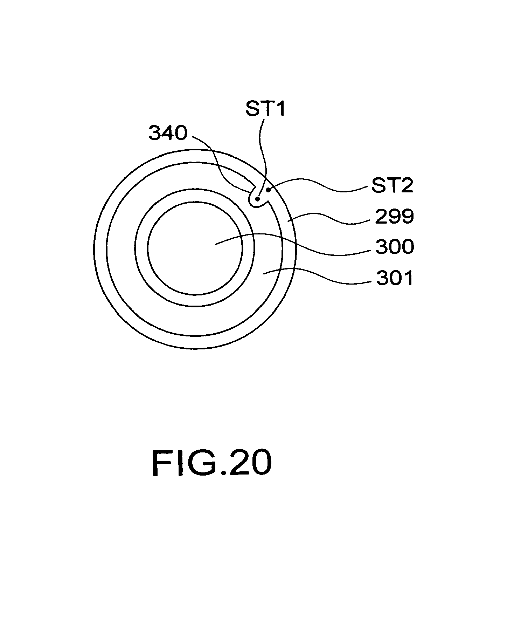

Instead, with respect to the shapes of the first electrode 300 and the second electrode 301, as shown in Fig. 20, the first electrode 300 and the second electrode 301 are formed in concentric ring shapes. The second electrode 301 surrounds the outer periphery of the first electrode 300. The insulation member 299 has a notch portion 340. In the notch portion 340, there are a contact position ST1 that the conductive needle 303 contacts on the rear surface of the semiconductor wafer W and a contact position ST2 that the conductive needle 305 contacts on the treatment surface of the semiconductor wafer W.

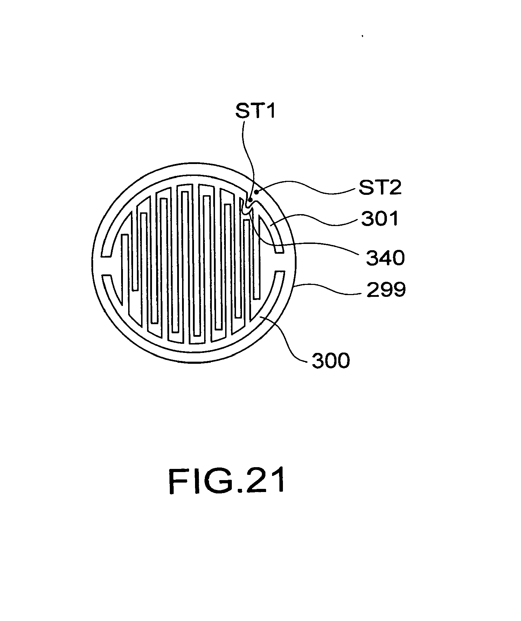

Instead, with respect to the shapes of the first electrode 300 and the second electrode 301, as shown in Fig. 21, the first electrode 300 and the second electrode 301 are formed in a comb shape and mated each other. The insulation member 299 has a notch portion 340. In the notch portion 340, there are a contact position ST1 that the conductive needle 303 contacts on the rear surface of the semiconductor wafer W and a contact position ST2 that the conductive needle 305 contacts on the treatment surface of the semiconductor wafer W.

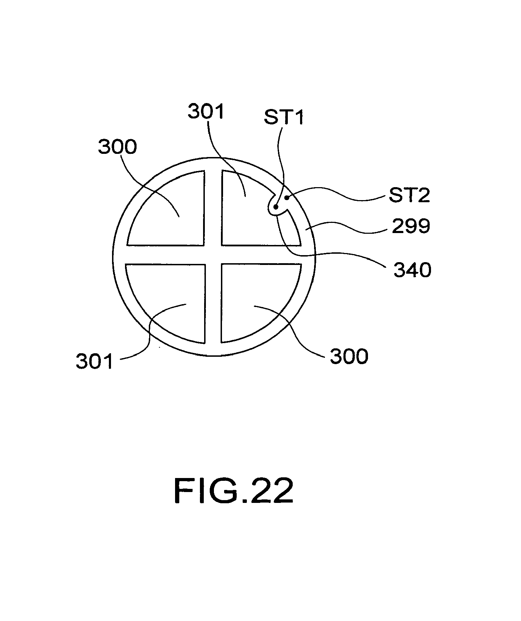

Instead, with respect to the shapes of the first electrode 300 and the second electrode 301, as shown in Fig. 22, a pair of electrodes as two opposite arc-shaped portions of a four-divided circle are the first electrode 300, whereas another pair of electrodes as two opposite arc-shaped portions of the four-divided circle are the second electrode 301. The insulation member 299 has a notch portion 340. In the notch portion 340, there is a contact position ST1 that the conductive needle 303 contacts on the rear surface of the semiconductor wafer W and a contact position ST2 that the conductive needle 305 contacts on the treatment surface of the semiconductor wafer W.

Thus, the contact position ST1 that the conductive needle 303 contacts on the rear surface of the semiconductor wafer W is closer to the center position of the semiconductor wafer W than is the contact position ST2 that the conductive needle 305 contacts on the treatment surface of the semiconductor wafer W. The conductive needles are used to remove electrons that are present in the semiconductor wafer W and static electricity charged by the electrostatic chuck. However, the conductive needle 305 on the treatment surface of the semiconductor wafer W cannot be approached close to the center position of the semiconductor wafer W because an electron beam needs to emitted to the resist film on the semiconductor wafer for the exposure treatment. The conductive needle 305 is contacted to the insulation member 299 on the treatment surface of the semiconductor wafer W. This is because if the conductive needle 305 were contacted to the outside of the insulation member 299 on the treatment surface of the semiconductor wafer W, the conductive needle 305 would cause the semiconductor wafer W to disperse.

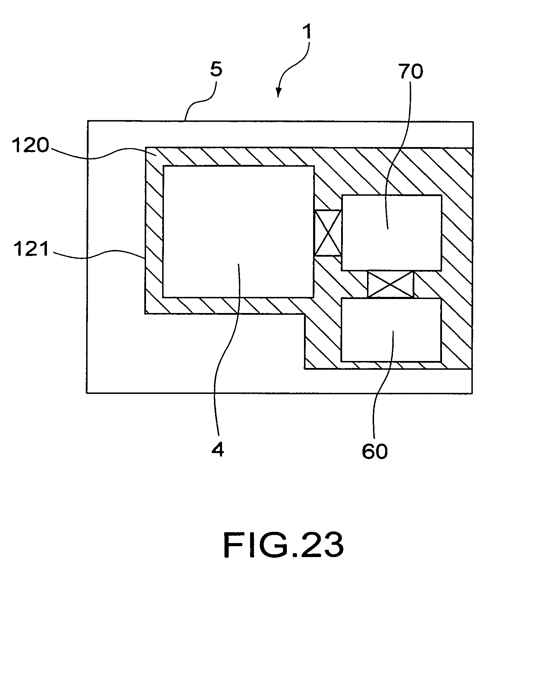

With respect to a structure of suppressing the penetration of magnetism in the exposure treatment chamber 4 that emits an electron beam to a semiconductor wafer W and performs the exposure treatment for a semiconductor wafer W, as shown in Fig. 23, the exposure treatment chamber 4, the reduced pressure conveying chamber 70, and the vacuum preparation chamber 60 are surrounded by a magnetism penetration suppressing mechanism, for example a magnetic shield member 121 such as a member made of a material such as perm alloy, electromagnetic soft steel, electromagnetic hard steel, Sendust, or ferrite. In the exposure treatment chamber 4, the reduced pressure conveying chamber 70, and the vacuum preparation chamber 60, an electron beam is affected by an external magnetism, for example it is deflected. Thus, the yield of semiconductor wafers W in the exposure treatment is affected. Although the whole apparatus may be surrounded by magnetic shield member 121, in this case, the size of the apparatus will increase. Thus, this approach would be neither practical, nor economical. In addition, since the apparatus has magnetism generation sources such as a control device and so forth, it is preferred that the exposure treatment chamber 4, the reduced pressure conveying chamber 70, and the vacuum preparation chamber 60 be covered by the magnetic shield member 121. Instead, only the exposure treatment chamber 4 may be covered by the magnetic shield member 121. In this case, magnetism generates by the reduced pressure conveying chamber 70 and the vacuum preparation chamber 60 may not be sufficiently protected. Thus, it is necessary to cover at least the exposure treatment chamber 4 and the reduced pressure conveying chamber 70 by the magnetic shield member 121. It is preferred that the exposure treatment chamber 4, the reduced pressure conveying chamber 70, and the vacuum preparation chamber 60 be covered by the magnetic shield member 121.

Thus, an area 120 that is more than half of the floor area of the apparatus is covered by the magnetic shield member 121. In addition, it is preferred that the magnetic shield member 121 have a thickness and structure that allows the intensity of magnetic field inside the magnetic shield member 121 is half or less of the intensity of magnetic field outside the magnetic shield member 121 or the apparatus.

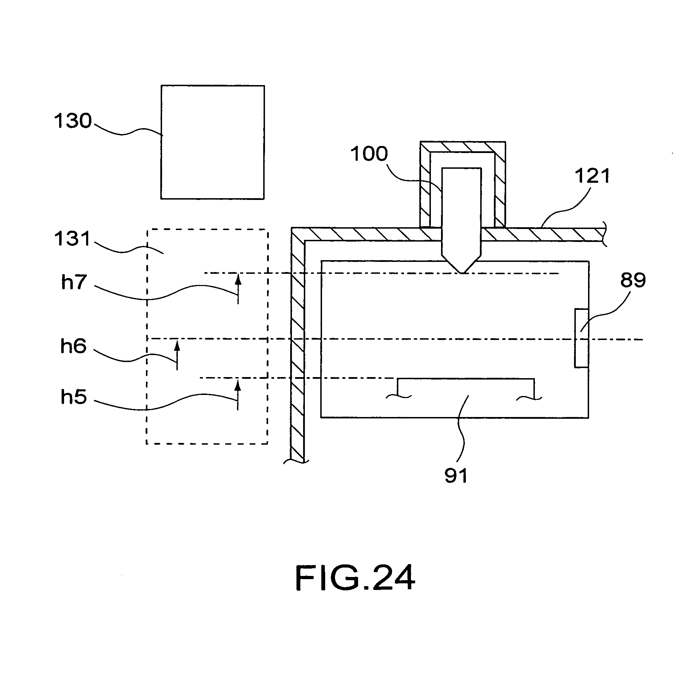

In addition, as shown in Fig. 24, as an example of magnetism generation sources, there is a power supply section as an energy source that generates an electron beam, for example an amplifier section 130. The amplifier section 130 is disposed opposite to the reduced pressure conveying chamber 70 of the exposure treatment chamber 4. The height of the bottom position of the amplifier section 130 is greater than the height h5 of the holding surface of the semiconductor wafer W on the stage 91. Preferably, the height of the bottom position of the amplifier section 130 is greater than the height h6 of the loading openings 89 from which the semiconductor wafer W is loaded into the exposure treatment chamber 4. More preferably, the height of the bottom position of the amplifier section 130 is greater than the height of radiation position h7 of an electron beam emitted from the column 100. This arrangement prevents an electron beam used for the exposure treatment from being adversely affected by electromagnetic waves emitted from the amplifier section 130. A maintenance space section 131 is disposed below the amplifier section 130. The maintenance space section 131 allows a worker to maintain the exposure treatment chamber 4 and so forth. Thus, not only influence of electromagnetic waves, but efficiency of a maintenance work is considered. Since the space of the apparatus is effectively used, the size of the apparatus is downsized and the foot print thereof is decreased.

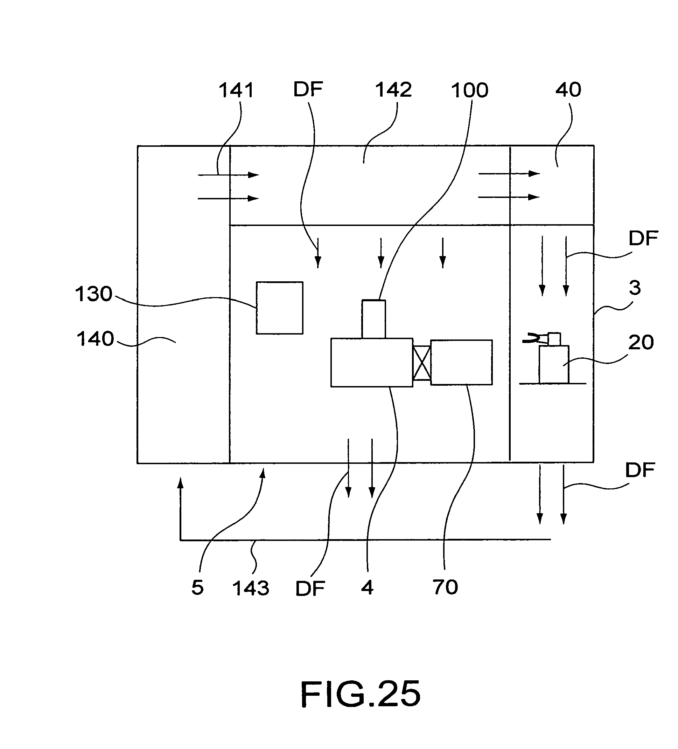

As shown in Fig. 25, a gas supplying mechanism 140 is disposed opposite to the atmospheric aligner section 3 of the exposure treatment section 5. The gas supplying mechanism 140 supplies a gas, for example clean air to the whole apparatus. At least the temperature and humidity of the clean air are controlled. The gas supplying mechanism 140 also supplies clean air 141 to the FFU 40 through a gas flow path 142 disposed above the exposure treatment section 5. In addition, the gas supplying mechanism 140 supplies the clean air 141 to the exposure treatment section 5 through the gas flow path 142 at a predetermined flow rate so that a down-flow DF takes place in the exposure treatment section 5. The clean air 141 is collected at lower positions of the exposure treatment section 5 and the atmospheric aligner section 3. The collected clean air 141 is supplied to the gas supplying mechanism 140 through a gas collection path 143. As a result, a recycling system is effectively achieved.

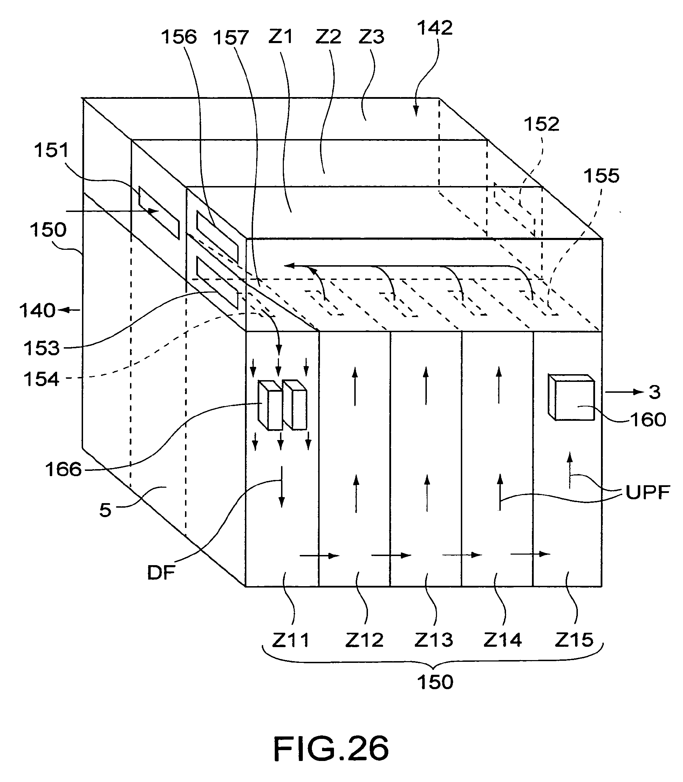

As shown in Fig. 26, the gas flow path 142 is divided into a plurality of zones Z1, Z2, and Z3. In addition, a plurality of air flow paths 150 are disposed on both wall sides of the exposure treatment section 5. Each of the air flow paths 150 has a plurality of vertical zones Z11, Z12, Z13, Z14, and Z15. The zone Z2 of the gas flow path 142 has an air supplying opening 152 that is a flow path through which clean air supplied from the gas supplying mechanism 140 and taken from an air taking opening 151 is supplied to the exposure treatment section 5 and the FFU 40.

The zone Z1 and the zone Z3 of the gas flow path 142 have an air supply opening 153 through which clean air is supplied from the gas supplying mechanism 140 to a flow path of at least one zone, for example the zone Z11 of the gas flow path 150. The supplied clean air is taken from a gas taking opening 154 disposed above a flow path of the zone Z11. The taken clean air forms a down-flow DF that flows downward as shown in Fig. 26. The down-flow DF is guided to flow paths of the zones Z12, Z13, Z14, and Z15 from a lower position of the flow path of the zone Z11. The guided clean air forms up-flows UPF in the plurality of zones Z12, Z13, Z14, and Z15 as shown in Fig. 26. All the up-flows UPF in the flow paths of the plurality of zones Z12, Z13, Z14, and Z15 are collected to the gas flow path 142 through gas collection openings 155. The collected air is supplied to the gas supplying mechanism 140 through a gas collection opening 156. As a result, a recycling system is effectively achieved.

Thus, a partition plate 157 as a gas separation member is disposed in the flow paths of the zones Z1 and Z3 so that a gas supply path of clean air to the zone Z11 and a gas collection path of clean air from the zones Z12, Z13, Z14, and Z15 are formed. Disposed in the follow path of the zone Z11 in which a down-flow is formed is a heat source, for example a control mechanism 166 of the exposure treatment section 5. Disposed in the zone Z15 in which an up-flow UPF is formed is an operation mechanism of the control mechanism 166, for example an operation panel 160, whose heat generation is smaller than the control mechanism 166.

The magnetic shield prevents magnetism from entering the inside of the apparatus. In addition, heat management is performed outside the magnetic shield. Thus, the whole system can be prevented from being environmentally affected. In addition, the system prevents itself from affecting the environment of the outside. Alternatively, a heat source may be provided to at least one of the up-flow UPF zones Z12, Z13, Z14, and Z15 and heat caused by the heat source may be actively collected, heat can be prevented from staying in the apparatus. As a result, the influence of heat against the treatment chamber may be suppressed. Thus, the yield of semiconductor wafers W may be preferably improved.

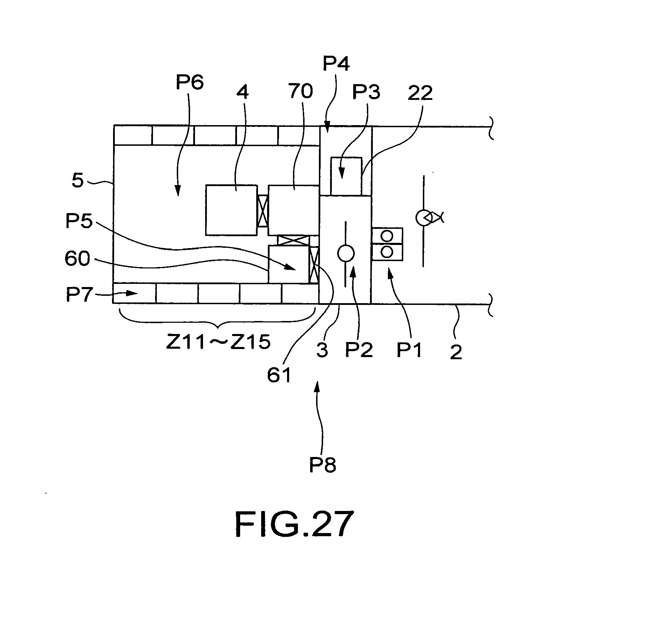

With respect to the relationship of inner pressures of individual sections of the apparatus, as shown in Fig. 27, when the inner pressure of the resist treatment device 2 is denoted by P1, the inner pressure of the atmospheric aligner section 3 is denoted by P2, the inner pressure of the heat treatment section 22 is denoted by P3 (when heat treatment section 22 has an opening and closing mechanism, it is open), the pressure in the space of the heat treatment section 22 is denoted by P4 (clean air may be supplied from the gas supplying mechanism 140 or a down-flow may be formed by clean air supplied from the FFU 40), the inner pressure of the vacuum preparation chamber 60 is denoted by P5 (when an opening and closing mechanism 61 is open), the inner pressure of the exposure treatment section 5 is denoted by P6, the inner pressure of the zones Z11, Z12, Z13, Z14, and Z15 is denoted by P7, and the inner pressure of the clean room in which the apparatus is disposed is denoted by P8, the conditions of P6 > P2, P1 > P2, P5 > P2, P2 > P4, P2 > P3, and P6 ≥ P7 are kept. The conditions of P6 > P2, P1 > P2, and P5 > P2 are kept because clean air is prevented from flowing from the atmospheric aligner section 3[ 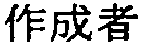 1] to the treatment chambers of the resist treatment device 2 and the exposure treatment section 5. As a result, the problem of cross contamination of the apparatus can be solved.

In addition, when the inner pressure P8 of the clean room is compared with the conditions of P6 > P2, P1 > P2, and P5 > P2, the condition of P2 > P8 is kept. Thus, air in the clean room is prevented from adversely affecting the treatment environment. Next, the relationship of P2 > P4 and P2 > 3 will be described. As was described above, vented gas from the heat treatment section 22 flows from the temperature adjustment mechanism side to the heat treatment mechanism side. These conditions prevent heat from affecting the conveying mechanism side. In addition, these conditions prevent particles that take place from a semiconductor wafer W for the heat treatment of the heat treatment mechanism from leaking into the conveying mechanism side. In addition, since there are heat generation sources such as a power supply section, a thermal treatment control mechanism, and so forth above the heat treatment section, these conditions prevent heat from leaking into the conveying mechanism side. Of course, when the inner pressures of the resist treatment device 2, and the exposure treatment chamber 4, the atmospheric aligner section 3, and the atmospheric aligner section 3 are compared with the inner pressure of the clean room, the conditions of (P2, P4, P3) > P8 are kept. With respect to the relationship of P4 and P3, it is preferred that the condition of P3 ≥ P4 is kept to prevent heat from affecting the heat treatment section 22.

In addition, the condition of P6 ≥ P7 is kept. This is because a down-flow is formed in the exposure treatment section 5. However, since the treatment chamber and so forth are disposed in the exposure treatment section 5, a part of the down-flow bents horizontally. Although gas is collected downwardly, since gas is prevented from being agitated in the apparatus, it is preferred that the inner pressure of the zone Z15, P7, be lower than the inner pressure of the exposure treatment section 5, P6, and that gas be collected on the side wall side even if gas leaks. In other words, even if a worker forgot to mount a panel in place during a maintenance work and a gap occurred, gas could be collected on the side wall side. When the inner pressure P6 of the exposure treatment section 5 and the inner pressure P7 of the zones 11 to 15 are compared with the inner pressure P8 of the clean room the conditions of (P6, P7) > P8 are kept. Thus, air in the clean room can be prevent from adversely affecting the treatment environment.

With respect to the relationship of P5, P2, and P1, the conditions of P5 ≥ P1 > P2 are kept. These conditions prevent particles from entering the vacuum preparation chamber 60. When the inner pressure of the atmospheric aligner section 3 is compared with the inner pressure P8 of the clean room, the condition of P2 > P8 is kept.

With respect to the relationship of the inner pressure of the vacuum preparation chamber 60 (when the opening and closing mechanism 67 is open) and the inner pressure of the reduced pressure conveying chamber 70 (when the opening and closing mechanism 67is open), the condition of which the inner pressure of the vacuum preparation chamber 60 be equal to or greater than the inner pressure of the reduced pressure conveying chamber 70 is kept. Preferably, the condition of which the inner pressure of the vacuum preparation chamber 60 be greater than the inner pressure of the reduced pressure conveying chamber 70 is kept. With respect to the relationship of the inner pressure of the reduced pressure conveying chamber 70 (when an opening and closing mechanism 92 is open) and the inner pressure of the exposure treatment chamber 4 (when the opening and closing mechanism 92 is open), the condition of which the inner pressure of the exposure treatment chamber 4 be equal to or greater than the inner pressure of the reduced pressure conveying chamber 70 is kept. Preferably, the condition of which the inner pressure of the exposure treatment chamber 4 be greater than the inner pressure of the reduced pressure conveying chamber 70 is kept. This condition allows particles that take place in the vacuum preparation chamber 60 to be collected by the reduced pressure conveying chamber 70 and prevents particles from entering the exposure treatment chamber 4.

Thus, in this condition, the yield of substrates under treatment is improved. With respect to the relationship of the inner pressure of the reduced pressure conveying chamber 70 and the inner pressure of the vacuum preparation chamber 60, preferably, the conditions of which the inner pressure of the vacuum preparation chamber 60 is greater than the inner pressure of the exposure treatment chamber 4, the inner pressure of the exposure treatment chamber 4 is greater than the inner pressure of the reduced pressure conveying chamber 70 are kept.

With respect to inner temperatures, the condition of which the inner temperature of the resist treatment device 2 is equal to or greater than the inner temperature of the atmospheric aligner section 3 is kept. Preferably, the condition of which the inner temperature of the resist treatment device 2 is greater than the inner temperature of the atmospheric aligner section 3 is kept. As described above, the difference between the inner temperature of the atmospheric aligner section 3 and the inner temperature of the resist treatment device 2 is small, for example from a fraction of 1 °C to 3 °C, preferably, from 0.1 to 0.5 °C. This condition prevents the resist film formed on a semiconductor wafer W from expanding and shrinking and thereby the accuracy of the exposure treatment from deteriorating. When a semiconductor wafer W is conveyed to the load lock (vacuum preparation chamber 60) with the temperature adjustment plate 27 whose temperature is slightly higher than the temperature of the upper portion of the stage 91, the decrease of the temperature of the semiconductor wafer W due to the vacuum venting of the load lock (vacuum preparation chamber 60) can be offset. In addition, the conditions of which the inner temperature of the atmospheric aligner section 3 is equal to the inner temperature of the exposure treatment section 5 and the inner temperature of the exposure treatment section 5 is equal to the inner temperature of the zones Z11, Z12, Z13, Z14, and Z15 are kept. In this description, the phrase "equal to" means "nearly" that implies an error within 3 °C.

With respect to the relationship of inner humidities, the conditions of which the inner humidity of the atmospheric aligner section 3 is equal to the inner humidity of the exposure treatment section 5, the inner humidity of the exposure treatment section 5 is equal to the inner humidity of the zones Z11, Z12, Z13, Z14, and Z15, and the inner humidity of the zones Z11, Z12, Z13, Z14, and Z15 is equal to the inner humidity of the vacuum preparation chamber 60 (when the opening and closing mechanism 61 is open) are kept. In addition, the condition of which the inner humidity of the atmospheric aligner section 3 is equal to or greater than the inner humidity of the vacuum preparation chamber 60 (when the opening and closing mechanism 61 is open) is kept. Preferably, the condition of which the inner humidity of the atmospheric aligner section 3 is greater than the inner humidity of the vacuum preparation chamber 60 (when the opening and closing mechanism 61 is open) is kept. Thus, of course, the condition of which the inner humidity of the resist treatment device 2 is greater than the inner humidity of the vacuum preparation chamber 60 (when the opening and closing mechanism 61 is open) is kept. This is because atmospheric pressure and reduced pressure take place in the vacuum preparation chamber 60. Thus, if moisture entered the vacuum preparation chamber 60, the throughput of the pressure reduction would decrease. Thus, it is necessary to cause an inert gas, for example N₂, to flow from the vacuum preparation chamber 60 to the atmospheric aligner section 3.

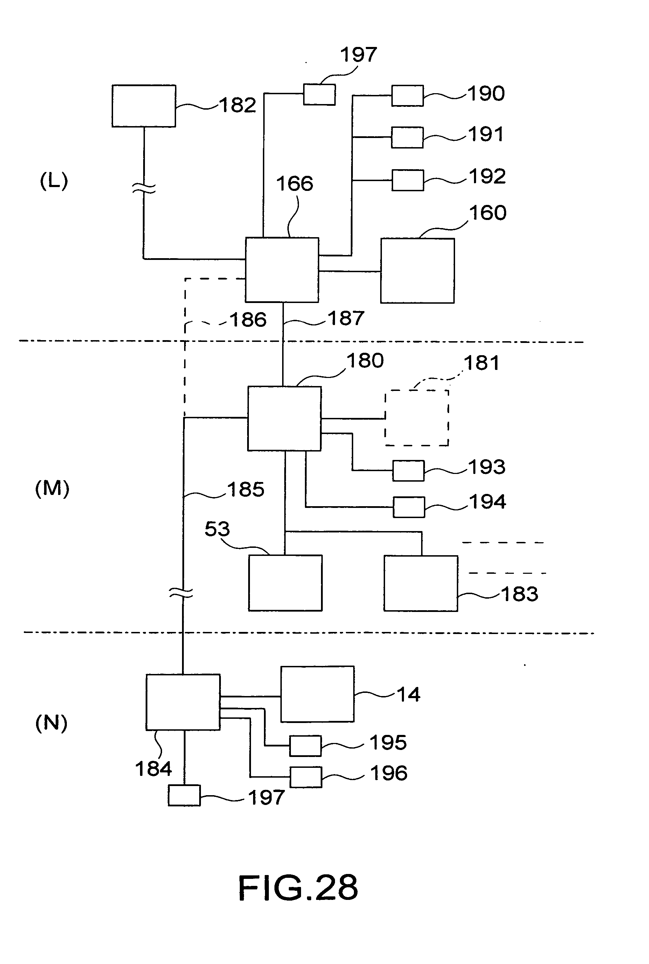

With respect to control signals and a control structure, as shown in Fig. 28, as described above, the control mechanism 166 is disposed in the exposure treatment section 5. In addition, an operation mechanism 160 is disposed. The operation mechanism 160 has a display mechanism. The control mechanism 166 controls individual devices of the exposure treatment section 5. The control mechanism 166 sends and receives signals to a management host computer (block L in Fig. 28) of the plant in which the apparatus is disposed. The atmospheric aligner section 3 has a control mechanism 180 that controls individual devices of the atmospheric aligner section 3. An operation mechanism 181 is connected to the control mechanism 180. The operation mechanism 181 has a display mechanism. The operation mechanism 181 may be shared by the operation mechanism 160. When necessary, if the atmospheric aligner section 3 is manufactured and sold as one independent unit or maintained, the operation mechanism 181 may be able to be freely connected to the atmospheric aligner section 3.

The control mechanism 180 sends and receives signals to and from the control mechanism 53 that controls the heat treatment section as described above. In addition, the control mechanism 180 sends and receives signals to and from a control mechanism 183 that controls the conveying mechanism 20 (block M in Fig. 28). In addition, the control mechanism 180 sends and receives signals to and from a control mechanism 184 on the resist treatment device 2 side through a signal line 185. The control mechanism 184 is connected to an operation panel 14. The operation panel 14 has a display mechanism. Signals that are sent and received to and from the resist treatment device 2 are signals that cause a semiconductor wafer W to be transferred between the conveying mechanism 20 and the passing portion 10 and the receiving portion 11 of the resist treatment device 2 and signals about atmospheric pressures in the resist treatment device 2.

By sending a signal about the inner atmospheric pressure of the atmospheric aligner section 3 to the control mechanism 184 of the resist treatment device 2 through the control mechanism 180, the atmospheric pressure may be checked mutually on the resist treatment device 2 side and the atmospheric aligner section 3 side. The control mechanism 166 may control the atmospheric pressure of the whole apparatus based on the information. In the foregoing example, the control mechanism 180 and the control mechanism 184 were described. Instead, the control mechanism 166 may receive a signal from the control mechanism 184 through a signal line 186. The control mechanism 166 may send a control command to the control mechanism 180.

The control mechanism 166 and the control mechanism 180 send and receive signals through a signal line 187. Since the control mechanism 166 manages the whole apparatus, the control mechanism 166 can freely receive signals about the states of individual functions of the atmospheric aligner section 3 from the control mechanism 180. One of important signals that the control mechanism 166 sends to the control mechanism 180 is a signal that causes the control mechanism 180 to control the control mechanism 53 to start the heat treatment based on the start time or the end time of the exposure treatment for a semiconductor wafer W in the exposure treatment chamber 4.

Since the state of a resist film formed on a semiconductor wafer W deteriorates with time, it is one of factors that cause the yield of semiconductor wafers W to decrease. Thus, the time management from exposure treatment to PEB heat treatment is important. Since the control mechanism 166 manages the whole exposure device, the yield of semiconductor wafers W is prevented from decreasing.

Since the state of a resist film formed on a semiconductor wafer W deteriorates with time, the control mechanism 184 on the resist treatment device 2 side informs the control mechanism 180 of the end time of resist coating. In addition, the control mechanism 184 informs the control mechanism 166 of time information such as conveying time in the atmospheric aligner section 3. The control mechanism 166 causes the exposure treatment chamber 4 to perform the exposure treatment for a semiconductor wafer W based on conveying times of a semiconductor wafer W and/or change factors of the state of a resist film formed on a semiconductor wafer W in the reduced pressure conveying chamber 70, the vacuum preparation chamber 60, and the exposure treatment chamber 4. The control mechanism 180 manages times such as the start time for PEB heat treatment for a semiconductor wafer W that has been exposed based on change factors of the state of the resist film and the information received from the control mechanism 166.

After the PEB heat treatment has been completed, the control mechanism 180 sends information about transfer time to the resist treatment device 2 and so forth to the control mechanism 184. The control mechanism 184 manages times for a semiconductor wafer W, for example the start time of the development treatment for a resist film formed on a semiconductor wafer W. Thus, a plurality of substrates can be prevented from becoming different in their treatments. As a result, the yield of semiconductor wafers W can be improved. In the foregoing description, the control mechanism 180 was provided. Instead, of course, the control mechanism 166 may contain at least a part of the functions of the control mechanism 180. Their information is stored in a storage mechanism, for example a nonvolatile memory or a CD-R, of each control mechanism and can be freely displayed on a display mechanism of each operation mechanism.

The control mechanism 166 or the control mechanism 180 can send time information such as the end time of the PEB heat treatment in the atmospheric aligner section 3 and/or atmospheric information about the atmospheric aligner section 3 to the control mechanism 184. The control mechanism 184 can manage the development start time. As a result, the yield of semiconductor wafers W can be improved. In addition, the control mechanism 166 or the control mechanism 180 receives information about the time at which the resist solution was coated on a semiconductor wafer W, information about the time at which the heat treatment was performed after coating of the resist solution, information about the heat treatment and manages the start time for the exposure treatment.

Connected to the control mechanism 166 are a pressure detection mechanism, for example a pressure sensor 190, that detects the pressure of a predetermined portion of the exposure treatment chamber 5, a pressure detection mechanism, for example a pressure sensor group 191, that detects pressures of predetermined portions of the zones Z11, Z12, Z13, Z14, and Z15, and a pressure detection mechanism, for example a pressure sensor 192, that detects the pressure of a predetermined portion of the vacuum preparation chamber 60.

Connected to the control mechanism 180 are a pressure detection mechanism, for example a pressure detection sensor 193, that detects the pressure of a predetermined portion of the atmospheric aligner section 3, and a chemical detection mechanism 194 that detects a chemical component, for example ammonia or the like, of a predetermined portion of the atmospheric aligner section 3. Connected to the control mechanism 184 are a pressure detection mechanism, for example a pressure sensor 195 that detects the pressure of a predetermined section of the resist treatment device 2, and a chemical detection mechanism 196 that detects a chemical component, for example ammonium, of a predetermined section of the resist treatment device 2.

Connected to the control mechanism 166 and/or the control mechanism 184 is a pressure detection mechanism, for example a pressure sensor 197, that detects the pressure outside the apparatus, for example the inner pressure of the clean room in which the apparatus is disposed. In such a manner, the pressure and so forth of the individual sections can be monitored. Since a chemical component that is present in the treatment section of the resist treatment device 2 is one of factors that adversely affect the treatment of a semiconductor wafer W, the chemical detection mechanisms in the resist treatment device 2 and the atmospheric aligner section 3 monitor a chemical component that is present therein. Thus, a chemical component needs to be monitored not only in the resist treatment device 2, but in the atmospheric aligner section 3.

The substrate treatment apparatus according to this embodiment is structured as described above. Next, operations for treatments of a semiconductor wafer W will be described.

First, the coating device (coater COT) of the resist treatment device 2 coats resist solution on the treatment surface of a semiconductor wafer W. Thereafter, a heating treatment is performed for the semiconductor wafer W at a predetermined temperature. Thereafter, the temperature of the semiconductor wafer W is adjusted to nearly the same temperature as the inner temperature of the resist treatment device 2. Thereafter, the semiconductor wafer W is conveyed to the alignment mechanism 15. The alignment mechanism 15 aligns the semiconductor wafer W (this operation is referred to as the first alignment of the resist treatment device 2). Thereafter, the semiconductor wafer W is conveyed to the passing portion 10 by the conveying mechanism 12. The passing portion 10 aligns the semiconductor wafer W by physically placing the semiconductor wafer W in a predetermined position (this operation is referred to as the second alignment of the resist treatment device 2). After the control mechanism 184 has checked the presence or absence of a semiconductor wafer W at the passing portion 10 with a sensor, the control mechanism 184 sends a "conveyance ready completion" signal to the control mechanism 166 and/or the control mechanism 180.

When the control mechanism 166 and/or the control mechanism 180 has received the "conveyance ready completion" signal, the semiconductor wafer W is received from the passing portion 10 by the conveying mechanism 20. Thereafter, the control mechanism 166 and/or the control mechanism 180 checks the presence or absence of the semiconductor wafer W with a sensor of the conveying mechanism 20 and then sends a "conveyance completion" signal to the control mechanism 184. During this operation, the semiconductor wafer W is conveyed to the alignment mechanism 21 by the conveying mechanism 20. The alignment mechanism 21 aligns the semiconductor wafer W (this operation is referred to as the alignment of the atmospheric aligner section 3). During the conveying operation, the temperature of the semiconductor wafer W is adjusted to nearly the same temperature as the inner temperature of the resist treatment device 2 or to a lower temperature than the inner temperature of the resist treatment device 2 with the inner temperature of the atmospheric aligner section 3.

Thereafter, the semiconductor wafer W is conveyed to the vacuum preparation chamber 60, which is a substrate loading and unloading section of the exposure treatment section 5, by the conveying mechanism 20. The vacuum preparation chamber 60 is vented so that a positive pressure higher than the inner atmospheric pressure of the atmospheric aligner section 3 becomes a predetermined reduced pressure (this reduced pressure is the same as the pressure at which the semiconductor wafer W is transferred to the reduced pressure conveying chamber 70, which will be described later. When the inner pressure of the vacuum preparation chamber 60 is slightly lower than the inner pressure of the reduced pressure conveying chamber 70, particles can be prevented from entering the reduced pressure conveying chamber 70). After the vacuum preparation chamber 60 has been vented or while it is being vented, the state of the semiconductor wafer W is detected by a plurality of CCD cameras 65 (position detection step). Thereafter, the opening and closing mechanism 67 is opened. Thereafter, the semiconductor wafer W is conveyed from the vacuum preparation chamber 60 to the reduced pressure conveying chamber 70 by the conveying mechanism 72 of the reduced pressure conveying chamber 70. Thereafter, the opening and closing mechanism 67 is closed.

Thereafter, the vacuum pump 83 is driven so that the inner pressure of the reduced pressure conveying chamber 70 is nearly the same as the inner pressure of an exposure treatment section 90 (the inner pressure of the reduced pressure conveying chamber 70 may be slightly lower than the inner pressure of the exposure treatment section 90 so as to prevent particles from entering the exposure treatment section 90). Thereafter, the opening and closing mechanism 92 is opened. The conveying mechanism 72 adjusts the angle of approach of the semiconductor wafer W to the exposure treatment section 90 corresponding to position data detected by the CCD cameras 65. Before or after the semiconductor wafer W is conveyed, the stage 91 of the exposure treatment section 90 is moved to an expected transfer position at which the semiconductor wafer W is transferred to the conveying mechanism 72 (this operation is referred to as the first alignment of the exposure treatment section 5).

The semiconductor wafer W is placed on a support mechanism disposed in the stage 91. The support mechanism supports the rear surface of the semiconductor wafer W. The support mechanism receives the semiconductor wafer W from the conveying mechanism 72 by raising a plurality of support pins. The support mechanism places the semiconductor wafer W on an insulation portion 299 of the electrostatic chuck mechanism 110 by lowering the support pins. While or after the semiconductor wafer W is placed on the insulation portion 299, the conveying mechanism 72 retreats from the exposure treatment section 90. Thereafter, the opening and closing mechanism 92 is closed.

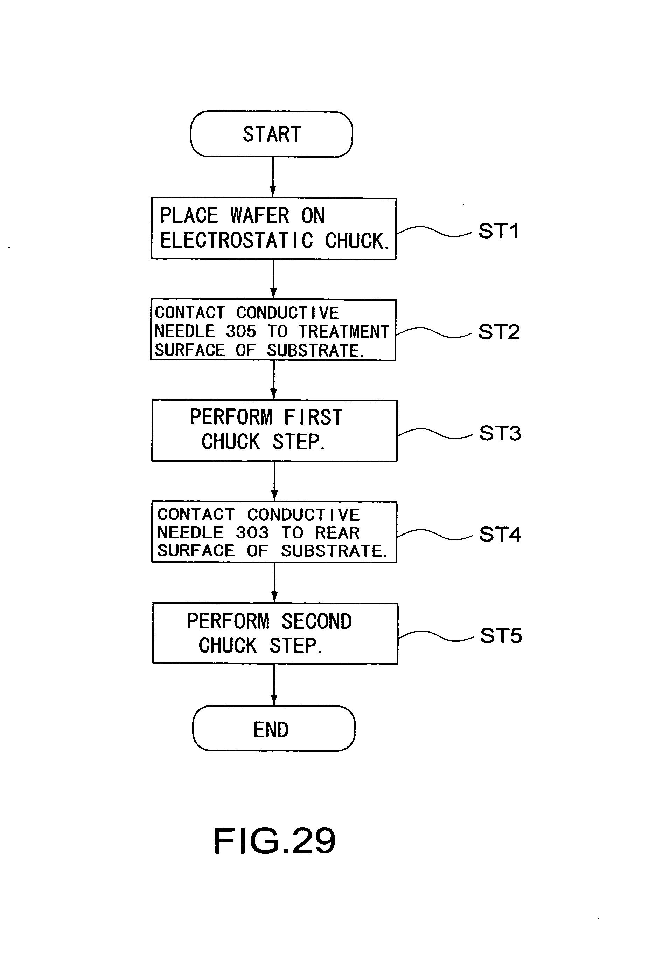

Next, with reference to Fig. 29 (outlined flow chart), sucking steps at which the electrostatic chuck mechanism 110 sucks a semiconductor wafer W will be described. As shown in Fig. 29, the semiconductor wafer W is placed on the insulation portion 299 of the electrostatic chuck mechanism 110 (at step ST1). Thereafter, the conductive needle 305 is moved and contacted to the predetermined film on the treatment surface of the semiconductor wafer W by the raising and lowering mechanism 306 (at step ST2). Thereafter, at a first sucking step (that will be described later), the semiconductor wafer W is electrostatically sucked by the electrostatic chuck mechanism 110 (at step ST3). Thereafter, the conductive needle 303 is moved and contacted to the predetermined film on the rear surface of the semiconductor wafer W by the raising and lowering mechanism 304 as a conveying mechanism (at step ST4). Thereafter, a second sucking step, that will be described later, is performed (at step ST5). Thereafter, the sucking step for the semiconductor wafer W by the electrostatic chuck mechanism 110 is complete.

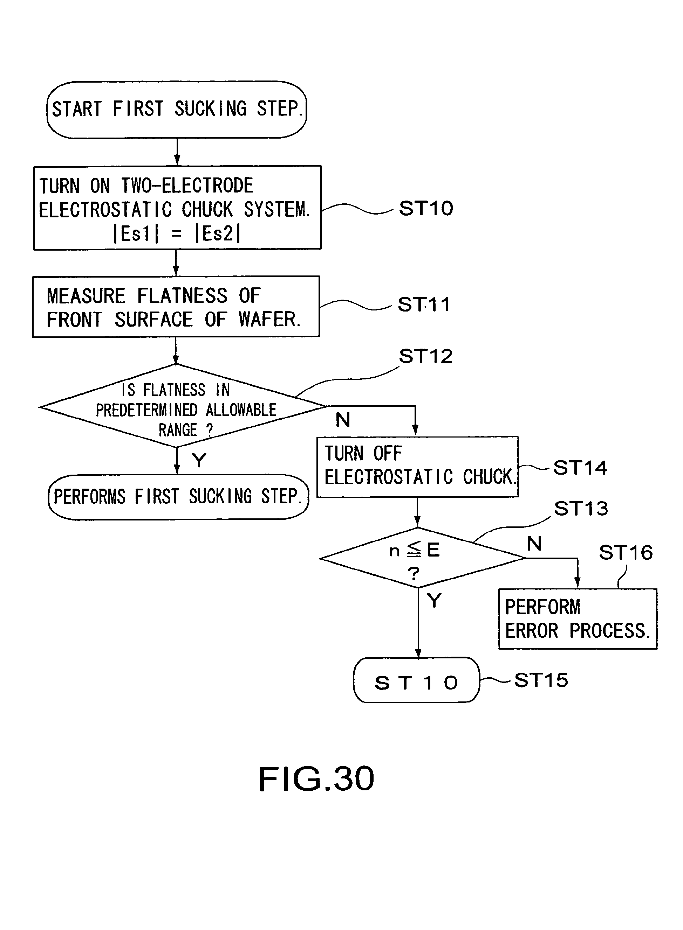

As shown in Fig. 30, at the first sucking step (at step ST 3), voltage Ea1 and voltage Ea2 are applied to the first electrode 300 and the second electrode 301, respectively, of the electrostatic chuck mechanism 110 on which the semiconductor wafer W is held. In this case, the control mechanism 166 controls the switches SW2 and SW5 shown in Fig. 5 to be closed, the switch SW3 to be placed at the VP1 position, and the switch SW4 to be placed at the VP4 position. The voltages Ea1 and Ea2 are the same voltages with different polarities. For example, the voltage Ea1 of the positions VP1 and VP4 is + 200 V. The voltage Ea2 of the positions VP3 and VP4 is - 200 V. The semiconductor wafer W is sucked and held on the insulation portion 299 using two electrodes (at step ST10).

Thereafter, the stage 91 is moved on the X and Y-axes. The flatness, for example the height of the surface, of the semiconductor wafer W on the insulation portion 299 is measured by a flatness detecting mechanism, for example a height sensor (not shown) (at step ST11). Thereafter, a control mechanism 116 determines whether the measured flatness is in a predetermined allowable range (at step ST12). When the determined result indicates that the measured flatness is in the predetermined allowable range, the first sucking step is completed. When the determined result indicates that the measured flatness is not in the predetermined allowable range, the voltage of the electrostatic check is turned off (at step ST14). Thereafter, the process is retried from step ST10. At step ST13, it is determined how many times the retry is performed. The value of E is input from the operation panel of the control mechanism 166. When the input value of E is 2, the retry is performed up to two times. When the input value of E is 0, of course, no retry is performed. In this case, an error process is performed at step ST16.

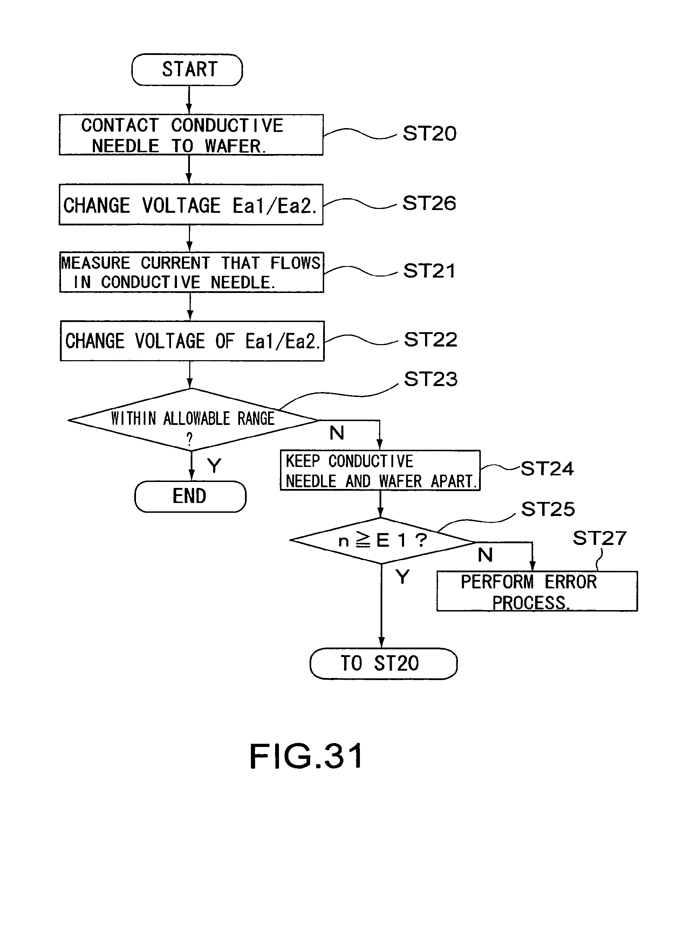

When the error process is performed, it is necessary to keep the semiconductor wafer W and the electrostatic chuck mechanism 110 apart. However, since there is static electricity between the semiconductor wafer W and the electrostatic chuck mechanism 110, it is necessary to diselectrify the semiconductor wafer W so that the static electricity charged therein becomes a predetermined value or less. In this process, as shown in Fig. 31, the conductive needle 303 is lowered and contacted to the predetermined film on the treatment surface of the semiconductor wafer W by the raising and lowering mechanism 304 (at step ST20). The voltage Ea1 of the first electrode 300 and the voltage Ea2 of the second electrode 301 are changed (at step ST26). In other words, the voltages Ea1 and Ea2 are relatively changed so that the voltage Ea1 and the voltage Ea2 of the power supply VP4 become + 200 V and - 100 V, respectively. The current value of a leak current that flows in the conductive needle 303 due to changes of the voltages Ea1 and Ea2 is measured by the ammeter 320 of the (unbalance state) switch terminal (at step ST21).

When the current value of the leak current is measured, if the measured value is out of the allowable range, the voltages Ea1 and Ea2 are further changed by predetermined values (at step ST22). If the current value of the leak current is in the allowable range, the diselectrifying step for the semiconductor wafer W and the electrostatic chuck mechanism 110 is completed. Thereafter, it is checked that the conductive needle 305 and the conductive needle 303 are not contacted to the semiconductor wafer W. Thereafter, the semiconductor wafer W is kept apart from the electrostatic chuck mechanism 110. The semiconductor wafer W is unloaded from the exposure treatment chamber 4 by the conveying mechanism 72. If the current value of the leak current is not in the allowable range, the conductive needle 303 is kept apart from the semiconductor wafer W by the raising and lowering mechanism 304 (at step ST24). Thereafter, the process is retried from step ST20. At step ST25, it is determined how many times the retry is performed. The value of E1 is input from the operation mechanism 160 of the control mechanism 166. When the value of E1 is 2, the retry is preformed up to two times. When the input value of E1 is 0, of course, no retry is preformed. In this case, the error process is performed at step ST27. When the error process is performed at step ST27, it is difficult to keep the semiconductor wafer W and the electrostatic chuck mechanism 110 apart. If the semiconductor wafer W were forced to keep the semiconductor wafer W and the electrostatic chuck mechanism 110 apart, the semiconductor wafer W would be damaged. Thus, it is preferred that the error process at step ST27 be performed as a maintenance work by a qualified person.

In the foregoing process, the current value of the leak current was measured by the conductive needle 303. Instead, the current value of the leak current may be measured by the conductive needle 305 or both by the conductive needle 305 and the conductive needle 303. When the semiconductor wafer W and the electrostatic chuck mechanism 110 are kept apart, the conductive needle 305 or both the conductive needle 305 and the conductive needle 303 may be used. When necessary, the conductive needle 303 and/or the conductive needle 305 may be flexibly used.

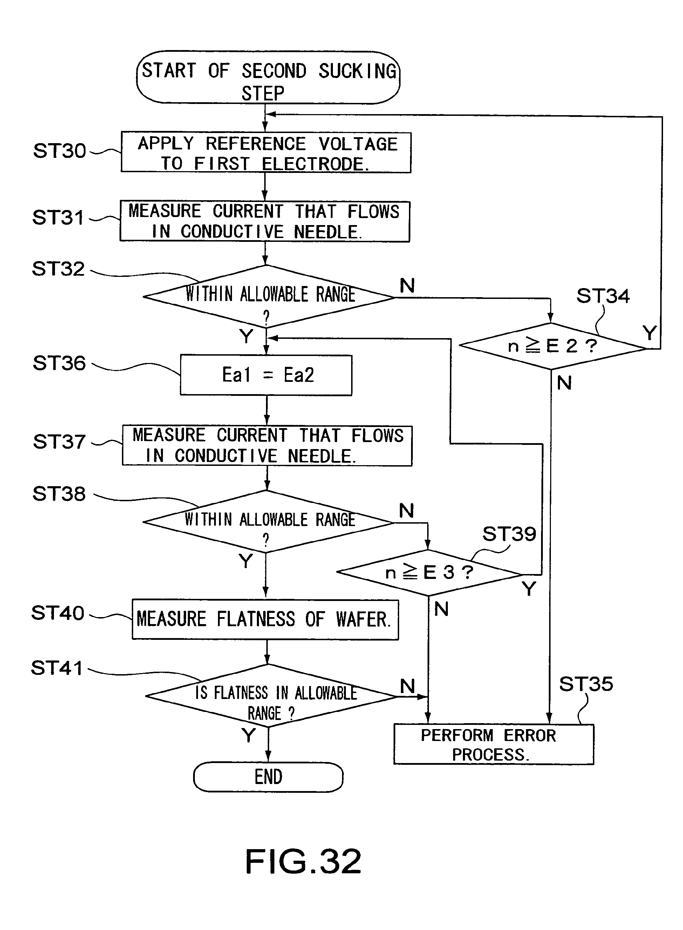

As shown in Fig. 32, the second sucking step (at step ST4), the center terminal of the switch SW3 is selected so that the reference voltage VP4 is applied to the first electrode 300 (at step ST30). (When the GND terminal of the switch SW4 is selected, 0 V is applied to the first electrode 300). The voltage Ea2 applied to the second electrode 301 is not changed. In this state, the current value of the leak current that flows in the conductive needle 303 is measured by the ammeter (at step ST31). It is determined whether the current value of the leak current is in a predetermined allowable range (at step ST32). When the current value of the leak current is out of the allowable range, the process is retried from step ST30. At step S34, it is determined how many times the retry is performed. The value of E2 is input from the operation mechanism 160 of the control mechanism 166. When the input value of E2 is 2, the retry is performed up to two times. When the input value of E2 is 0, of course, no retry is preformed. In this case, at step ST35, the error process is preformed.

When the leak current is in the predetermined allowable range, the left side terminal of the switch SW is selected so that the reference voltage VP2 + VP4 is applied to the first electrode 300 (at step ST36). The voltage Ea2 applied to the second electrode 301 and the voltage Ea1 applied to the first electrode 300 are the same voltage so that the electrostatic chuck functions as a single-electrode electrostatic chuck (at step ST33). Thereafter, the current value of the leak current that flows in the conductive needle 303 is measured (at step ST37). It is determined whether the current value of the leak current is in the predetermined allowable range (at step ST38). When the current value of the leak current is out of the allowable range, the retry is performed from step ST36. At step ST39, it is determined how many time the retry is preformed. The value of E3 is input from the operation mechanism 160 of the control mechanism 166. When the input value of E3 is 2, the retry is performed up to two times. When the input value of E3 is 0, of course, no retry is performed. In this case, the error process is performed at step ST35.

Thereafter, as described above, the flatness of the semiconductor wafer W is measured by a height sensor (at step ST40). It is determined whether the flatness of the semiconductor wafer W is in a predetermined allowable range (at step ST41). When the flatness is out of the allowable range, the error process is performed at step ST35. When the flatness of the semiconductor wafer W is in the predetermined allowable range, the second electrostatic check step is completed. Since the flatness of the semiconductor wafer W depends on the type of a circuit pattern formed thereon, a predetermined value of the flatness is input from the operation panel 160 of the control mechanism 166 depending on devices that are formed thereon. The predetermined value is stored in the storage mechanism of the control mechanism 166. At the foregoing step, the current value of the leak current is measured using the conductive needle 303. Instead, the current value of the leak current may be measured using the conductive needle 303 or both using the conductive needle 305 and the conductive needle 303. When necessary, the conductive needle 305 and/or the conductive needle 303 may be flexibly used.

Thereafter, the mark detection mechanism 105 of the exposure treatment section 90 detects an alignment mark on a semiconductor wafer W held by the electrostatic chuck mechanism 110 on the stage 91. The stage 91 is moved on the X and Y-axes corresponding to the detected data. Finally, the semiconductor wafer W is aligned (this operation is referred to as the second alignment of the exposure treatment section 5). After this alignment, an exposure treatment is performed, namely an electron beam is emitted from the column 100 to the resist film formed on the semiconductor wafer W at an acceleration voltage in the range from 1 kV to 60 kV, preferably in the range from 1 kV to 10 kV, more preferably 5 kV so that a predetermined pattern is formed on the semiconductor wafer W. It is preferred that the acceleration voltage of the electron beam be set so that the electron beam acts on the resist film formed on the semiconductor wafer W. It is necessary to prevent electrons of the electron beam emitted to silicon (Si), which is the base material of the semiconductor wafer W, from diffusing.

After the exposure treatment, the stage 91 is moved to the transfer position of the semiconductor wafer W to the conveying mechanism 72. First, the voltages applied to the first electrode 300 and the second electrode 301 are turned off. Thereafter, the switches SW2 and SW5 are turned on. The current value of the leak current that flows in the conductive needle 303 and/or the conductive needle 305 is measured. When the current value is out of the predetermined allowable range, the predetermined voltage is applied to the conductive needle 303 and/or the conductive needle 305 at least one time or the error process is performed. When the determined result indicates that the current value of the leak current is in the predetermined range, after it is checked that the conductive needle 305 and the conductive needle 303 are kept apart from the semiconductor wafer W, the semiconductor wafer W is kept apart from the electrostatic chuck mechanism 110. Thereafter, the semiconductor wafer W is unloaded from the exposure treatment chamber 4 by the conveying mechanism 72.

Thereafter, the semiconductor wafer W is loaded into the vacuum preparation chamber 60 by the conveying mechanism 72. Next, the semiconductor wafer W is unloaded from the vacuum preparation chamber 60 by the conveying mechanism 20. The semiconductor wafer W is conveyed to the temperature adjustment plate 27 of the heat treatment section 22 by the conveying mechanism 20. The semiconductor wafer W is held on the temperature adjustment plate 27 or by the conveying mechanism 20 for a predetermined period of time (this period of time is constant for each of the plurality of semiconductor wafers W) based on information that the control mechanism 166 has calculated corresponding to the end time of the exposure treatment and a period of time for which the semiconductor wafer W has been placed in reduced pressure. Thereafter, the semiconductor wafer W is placed on the heating plate 26. The heating plate 26 performs a heat treatment for the semiconductor wafer W. Since the period of time for which the heat treatment is started needs to be constant for each of the plurality of semiconductor wafers W, it is necessary to manage the period of time for which the semiconductor wafer W is conveyed from the temperature adjustment plate 27 to the heating plate 26. When the semiconductor wafer W is held by the conveying mechanism 20, it is necessary to manage the period of time for which the semiconductor wafer W is conveyed from the conveying mechanism 20 to the temperature adjustment plate 27 and the period of time for which the semiconductor wafer W is conveyed from the temperature adjustment plate 27 to the heating plate 26.

The semiconductor wafer W for which the heat treatment has been performed at the predetermined temperature is transferred to the temperature adjustment plate 27. Thereafter, the semiconductor wafer W is transferred from the temperature adjustment plate 27 to the conveying mechanism 20. Thereafter, the semiconductor wafer W is unloaded from the heat treatment section 22 by the conveying mechanism 20. Thereafter, the semiconductor wafer W is temporarily aligned by the alignment mechanism 21 and then conveyed to the receiving portion 11 of the resist treatment device 2. Instead, the semiconductor wafer W may be directly conveyed to the receiving portion 11 of the resist treatment device 2. When the semiconductor wafer W is conveyed, the control mechanism 180 and/or the control mechanism 166 needs to ask the control mechanism 184 whether the receiving portion 11 has a semiconductor wafer W. Only when the control mechanism 180 and/or the control mechanism 166 has checked that the receiving portion 11 does not have a semiconductor wafer W, the conveying mechanism 20 conveys the semiconductor wafer W to the receiving portion 11. Before or after the semiconductor wafer W is conveyed to the receiving portion 11, the control mechanism 180 and/or the control mechanism 166 sends information about the semiconductor wafer W and information about the end time of the treatment of the heating plate 26 to the control mechanism 184.

The control mechanism 184 manages time information about individual sections of the apparatus corresponding to information received from the control mechanism 180 and/or the control mechanism 166 and conveys the semiconductor wafer W to the developing device (developer (DEV)). The developing device performs a developing treatment for the semiconductor wafer W. Thereafter, a sequence of operations is completed.

In the foregoing system that has an exposure treatment chamber that treats for example a substrate under treatment in for example reduced pressure, a reduced pressure conveying chamber having a conveying mechanism that conveys a substrate under treatment to the exposure treatment chamber in reduced pressure, a vacuum preparation chamber that can freely convey a substrate under treatment to the reduced pressure conveying chamber, and a linearly arranged atmospheric aligner section having a conveying mechanism that can freely convey a substrate under treatment to the vacuum preparation chamber in atmospheric pressure is especially effective if the foot print of the exposure treatment chamber is larger than the foot print of the reduced pressure conveying chamber or the foot print of the vacuum preparation chamber to some extent or if the foot print of the reduced pressure conveying chamber is the same as the foot print of the vacuum preparation chamber. However, when the reduced pressure conveying chamber or the vacuum preparation chamber is disposed adjacent to and along the linearly arranged atmospheric aligner section (the reduced pressure conveying chamber is disposed at the center of the atmospheric aligner section and the vacuum preparation chamber is disposed at one end of the atmospheric aligner section), the foot print of the whole system can be decreased in comparison with that of the related art. As a result, the whole system can be downsized. In particular, when the area of the foot print of the exposure treatment chamber is larger than that of the reduced pressure conveying chamber and the vacuum preparation chamber, the foregoing arrangement allows the foot print of the whole system to be decreased in comparison with that of the related art.

In the foregoing system, treatments for the exposure treatment chamber and the heat treatment chamber are centralized, namely controlled by one control mechanism. Thus, the system can highly mange substrates under treatment in consideration of improper treatments due to excessive treatment times and atmospheric states. Thus, the yield of substrates under treatment in the treatments can be improved. In addition, since the difference among a plurality of substrates under treatment can be suppressed, the yield thereof can be improved.

In addition, since temperature information about the heat treatment and/or information of the end time of the heat treatment is sent to a device side that coats resist solution on a substrate under treatment, the resist coating device can perform the treatment with a plurality of parameters based on these information. As a result, the yield of substrates under treatment can be improved.

In addition, when a substrate under treatment is aligned for the exposure treatment, since the accuracies of alignments of other devices are considered, the accuracy of the position of the substrate under treatment in the exposure treatment is improved. In addition, the yield of substrates under treatment in the exposure treatment can be improved or the throughput of alignments can be improved.

The electrostatic chuck mechanism has a plurality of electrodes and electrostatically sucks and holds a substrate using a single electrode or two electrodes. In addition, a leak current is monitored at each step. As a result, a substrate under treatment can be securely and safely electrostatically sucked. In addition, at each step, the flatness of a substrate under treatment is monitored. The substrate under treatment can be prevented from being improperly radiated with an electron beam. Thus, the exposure treatment can be accurately performed with an accurate radiation of an electron beam. Thus, the yield of substrates under treatment can be improved.

In addition, since a conductive needle is contacted to a predetermined film, not a base material, on the treatment surface or the rear surface of a substrate under treatment, the material of the substrate under treatment can be prevented from being damaged.

In addition, since the conductive needle contacts a predetermined film on the treatment surface or the rear surface of a substrate under treatment, an electric charge that is present on the treatment surface side or the rear surface side of the substrate under treatment can be effectively removed. As a result, an electric charge that is present between the substrate under treatment and the electrostatic chuck mechanism and an electric charge that is present on the treatment surface of the substrate under treatment due to radiation of an electron beam can be removed. As a result, the path of the electron beam can be prevented from being refracted due to the electric charge. In addition, the substrate under treatment can be securely kept apart from the electrostatic chuck mechanism. As a result, the yield of substrates under treatment can be improved.

In addition, the conductive needle is contacted to a predetermined film on the treatment surface or the rear surface of the substrate under treatment. A predetermined voltage is applied to the conductive needle. As a result, an electric charge that is present on the treatment surface side or the rear surface side of the substrate under treatment can be quickly decreased when necessary and at proper timing. Thus, an electron beam can be prevented from being refracted by the electric charge. In addition, the substrate under treatment can be securely kept apart from the electrostatic chuck mechanism. Thus, the yield of substrates under treatment can be improved.

The voltage of an electrode disposed on the side of the conductive needle that contacts a predetermined film on the treatment surface side or the rear surface side of the substrate under treatment in a plurality of electrodes of the electrostatic chuck mechanism is not changed. Instead, the voltage of an electrode that is apart from the conductive needle is changed. Thus, the deviation of sucking of the substrate under treatment can be suppressed. As a result, since the substrate under treatment can be prevented from being moved, it can be accurately radiated with an electron beam. Thus, the yield of substrates under treatment can be improved.

In addition, since the conductive needle (grounding mechanism) is contacted to the substrate under treatment through a holding area (insulation portion 299) of the holding table, the substrate under treatment can be prevented from being moved by the conductive needle. Thus, the position of the substrate under treatment radiated with an electron beam can be prevented from being moved. As a result, the yield of substrates under treatment can be improved.

Next, another embodiment of the present invention will be described. Unless otherwise specified, in this embodiment, similar structures and functions to those of the foregoing embodiment are denoted by similar reference numerals and their description will be omitted.

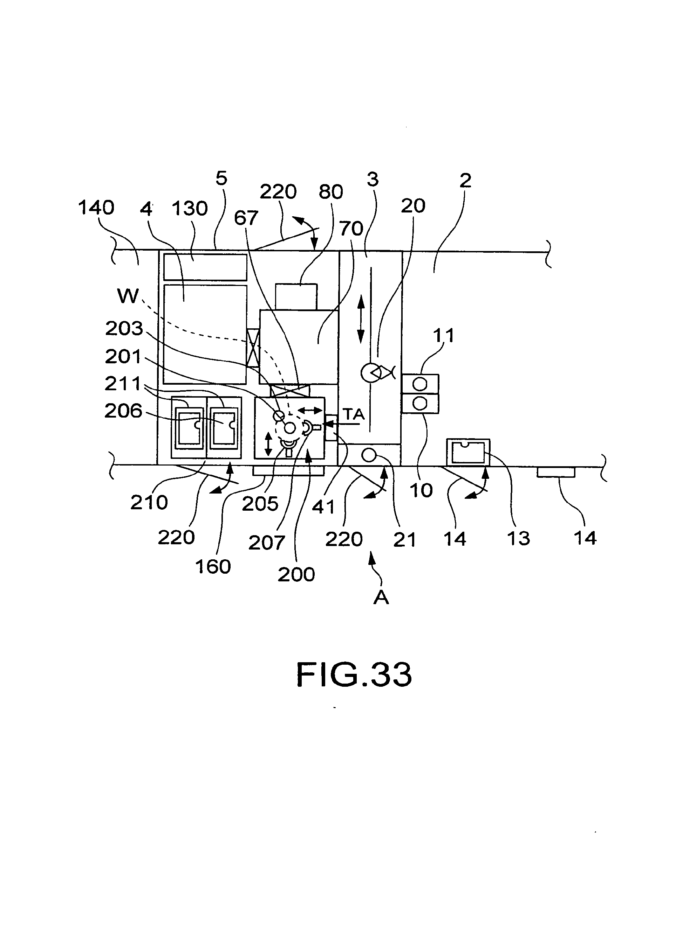

As shown in Fig. 33, an exposure treatment section 5 has a substrate loading and unloading section 200 into and from which a semiconductor wafer W is loaded and unloaded by a conveying mechanism 20 of an atmospheric aligner section 3. The substrate loading and unloading section 200 is disposed in an atmosphere of an exposure treatment section 5 or an atmosphere of the atmospheric aligner section 3. The substrate loading and unloading section 200 has a rotating member, for example a rotating table 201, that has a chuck mechanism. The chuck mechanism vacuum-sucks a semiconductor wafer W conveyed (from an arrow direction denoted by TA) by the conveying mechanism 20 of the atmospheric aligner section 3. The rotating table 201 can be freely raised and lowered by a raising and lowering mechanism, for example an air cylinder (not shown), that transfers the semiconductor wafer W to and from the conveying mechanism 20.

Disposed above the rotating table 201 is a detection section, for example a reflection type optical sensor 203 (or a CCD camera), that optically or visually detects a peripheral portion of a semiconductor wafer W held on the rotating table 201. While the rotating table 201 is being rotated, the peripheral portion, for example a notch portion of the semiconductor wafer W is detected by the optical sensor 230. Based on the detected notch portion, the semiconductor wafer W is aligned.

The substrate loading and unloading section 200 has a first conveying mechanism 205 and a second conveying mechanism 207. The first conveying mechanism 205 conveys a semiconductor wafer W placed on the rotating table 201 to a reduced pressure conveying chamber 70. The second conveying mechanism 207 is disposed opposite to the atmospheric aligner section 3 of the substrate loading and unloading section 200. The second conveying mechanism 207 can freely load and unload a semiconductor wafer W placed on the rotating table 201 to and from a container, for example a cassette 206, that can freely contain a plurality of semiconductor wafers W. The cassette 206 is placed on a cassette holding section 210 that can hold a plurality of cassettes 206. The cassette holding section 210 has a plurality of cassette raising and lowering mechanisms 211 each of which can freely raise and lower a cassette 206. The cassette raising and lowering mechanisms 211 each can transfer a semiconductor wafer W from and to the second conveying mechanism 207.

The cassette 206 can be freely loaded and unloaded to and from the cassette holding section 210 through an open and close mechanism. Since the exposure treatment section 5 has the cassette holding section 210 that loads and unloads a cassette 206, a test semiconductor wafer W can be treated only in the exposure treatment section 5. Even if a trouble occurs in the treatment of the exposure treatment section 5, since a semiconductor wafer W can be removed from the cassette holding section 210, the working efficiency is relatively improved.

In a work space A that is a common work space of the worker for a resist treatment device 2 as another device, both devices can be maintained. Thus, the working efficiency is improved. Operation panels 160 and 14 of these devices are disposed on the work space A side. Likewise, cassette holding sections 210 and 13 of these devices are disposed on the work space A side. When an alignment mechanism 21 of the atmospheric aligner section 3 is capable of taking a semiconductor wafer W from the work space A side through a door mechanism 220, not only the working efficiency of the worker can be improved, but the area of the foot print of the whole apparatus in the clean room can be decreased.

When the exposure treatment is performed only in the exposure treatment chamber 5 for a semiconductor wafer W unloaded from the cassette 206 on the cassette holding section 210, the second conveying mechanism 207 takes a semiconductor wafer W under treatment from the cassette 206 and places the semiconductor wafer W on the rotating table 201. While the rotating table 201 is being rotated, a peripheral portion, for example a notch portion, of the semiconductor wafer W is detected by the optical sensor 203 and aligned (this operation is referred to as the first alignment of the exposure treatment section 5). Thereafter, the semiconductor wafer W is conveyed to the reduced pressure conveying chamber 70 by the first conveying mechanism 205. The exposure treatment is performed for the semiconductor wafer W in an exposure treatment section 90. In the reverse order, the semiconductor wafer W is loaded into the cassette 206 by the second conveying mechanism 207. Of course, the position information obtained by the optical sensor 203 is considered when the semiconductor wafer W is conveyed from the reduced pressure conveying chamber 70 to the exposure treatment section 90.

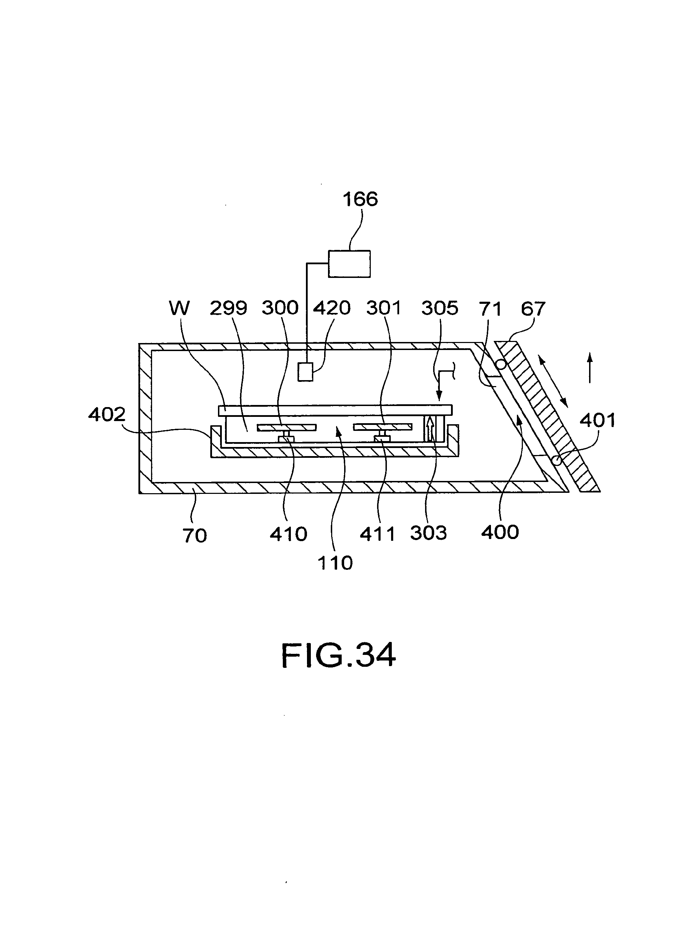

As shown in Fig. 34, a loading opening 71 of the reduced pressure conveying chamber 70 is tapered in the upper direction. In other words, an inclined portion 400 is formed so that the width of the ceiling surface of the reduced pressure conveying chamber 70 is smaller than that of the bottom surface. Thus, an opening and closing mechanism 67 can be moved in the diagonal directions. The interior of the reduced pressure conveying chamber 70 is kept airtight by an airtight mechanism, for example an O ring 401. The inclined portion 400 allows the volume of the reduced pressure conveying chamber 70 to be decreased in comparison with the case that the conveying opening 71 is formed upright. In other words, a decrease of the volume largely affects the throughput when a normal atmospheric pressure of the reduced pressure conveying chamber 70 is changed to a predetermined reduced pressure or vice versa.

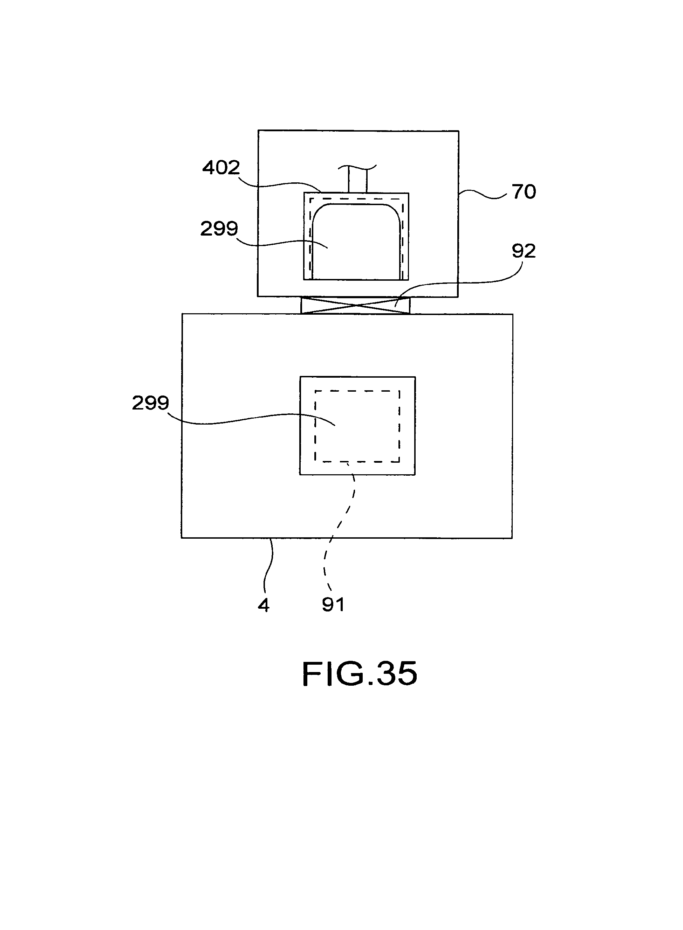

A semiconductor wafer W can be freely transferred to the reduced pressure conveying chamber 70 by the first conveying mechanism 205. The reduced pressure conveying chamber 70 has an electrostatic chuck mechanism 110 that holds a semiconductor wafer W. In addition, the reduced pressure conveying chamber 70 has a conveying mechanism 402 that can freely convey the electrostatic chuck mechanism 110 to the exposure treatment chamber 4. Thus, as shown in Fig. 35, the electrostatic chuck mechanism 110 that sucks and holds a semiconductor wafer W is conveyed to a stage 91 of the reduced pressure conveying chamber 70. The electrostatic chuck mechanism 110 is a pallet that has a function as a kind of a substrate conveying member.

As shown in Fig. 34, predetermined voltages are applied to the electrostatic chuck mechanism 110 on the conveying mechanism 402 through a conductive terminal 410 of a first electrode 300 and a conductive terminal 411 of a second electrode 301 disposed at bottom positions of the electrostatic chuck mechanism 110 so as to freely suck and hold a semiconductor wafer W. As described above, conductive needles 303 and 305 are disposed on the second electrode 301 side. The conductive needles 303 and 305 are contacted to the treatment surface and the rear surface of the semiconductor wafer W, respectively.

Thus, in the reduced pressure conveying chamber 70, a semiconductor wafer W is sucked by the electrostatic chuck mechanism 110. In addition, the conductive needles 303 and 305 are contacted to the semiconductor wafer W. In this state, the conveying mechanism 402 is conveyed to the stage 91 of the reduced pressure conveying chamber 70. When the conveying mechanism 402 is conveyed, even if the voltages applied to the conductive terminal 410 of the first electrode 300 and the conductive terminal 411 of the second electrode 301 are stopped, unless the semiconductor wafer W is diselectrified, a residual electric charge does not cause the semiconductor wafer W held on the electrostatic chuck mechanism 110 not to move. In addition, the conductive needles 303 and 305 need to be physically contacted to the rear surface side and the treatment surface side of the semiconductor wafer W by for example clips, respectively.

The electrostatic chuck mechanism 110 that holds a semiconductor wafer W in the reduced pressure conveying chamber 70 is conveyed to the stage 91. The stage 91 has terminals that contact the conductive terminal 410 of the first electrode 300 and the conductive terminal 411 of the second electrode 301 to supply predetermined powers to the terminals 410 and 411 from predetermined power supplies, respectively. Likewise, the conductive needles 303 and 305 need to be contacted to terminals connected to an ammeter and a GND, respectively.

The stage 91 and the electrostatic chuck mechanism 110 are secured in such a manner that the electrostatic chuck mechanism 110 is physically placed in a groove of the stage 91. However, it is preferred that the stage 91 have an electrostatic chuck mechanism that electrostatically sucks the electrostatic chuck mechanism 110. With the electrostatic chuck mechanism 110 secured to the stage 91, the exposure treatment is performed corresponding to the foregoing process or a part selected therefrom.

In Fig. 33, an amplifier section 130 is disposed opposite to the cassette holding section 210 of the exposure treatment chamber 4. Since a door mechanism 220 is disposed opposite to the work space A side or an gas supplying mechanism, namely the atmospheric aligner section 3 of the exposure treatment section 5, the maintenance work can be easily performed and the foot print of the exposure treatment section 5 can be decreased. While a semiconductor wafer W held on the electrostatic chuck mechanism 110 is being conveyed by the conveying mechanism 402 in the reduced pressure conveying chamber 70 or while a height sensor 420 disposed above the reduced pressure conveying chamber 70 is being moved, the flatness of the semiconductor wafer W can be detected by the height sensor 420.

In this system, in the reduced pressure conveying chamber 70 that is a pre-stage of the exposure treatment chamber 4, a predetermined process is performed. For example, the flatness of a semiconductor wafer W is detected. Thus, it is not necessary to perform such a process in the exposure treatment chamber 4. As a result, the movement of the stage 91 on the X and Y-axes can be reduced. Thus, mist such as particles can be prevented from occurring in the atmosphere of the exposure treatment chamber 4. As a result, the atmosphere of the exposure treatment chamber 4 can be kept clean. Thus, since an electron beam can be prevented from being adversely affected by mist or the like, the yield of semiconductor wafers W can be improved.

In the past, when an error process was preformed in a flatness test for an electrostatically sucked semiconductor wafer W in the exposure treatment chamber 4, it was necessary to convey the semiconductor wafer W from the exposure treatment chamber 4 to the reduced pressure conveying chamber 70. However, since the flatness of the semiconductor wafer W can be detected in the reduced pressure conveying chamber 70, the step of which the semiconductor wafer W is conveyed from the exposure treatment chamber 4 to the reduced pressure conveying chamber 70 can be omitted. Thus, since the error process can be omitted, the throughput of the error process and the like can be improved.

As described above, when the error process is performed in such a case that an electrostatically sucked semiconductor wafer cannot be diselectrified in the exposure treatment chamber 4, it is necessary to maintain the exposure treatment chamber 4. According to this embodiment, when necessary, since the electrostatic chuck mechanism 110 can be conveyed from the reduced pressure conveying chamber 70 to the substrate loading and unloading section 200, it is not necessary to maintain a reduced pressure device such as the exposure treatment chamber 4 and/or the reduced pressure conveying chamber 70. Thus, since the period of time for the maintenance work can be shortened, the throughput of the process can be improved.

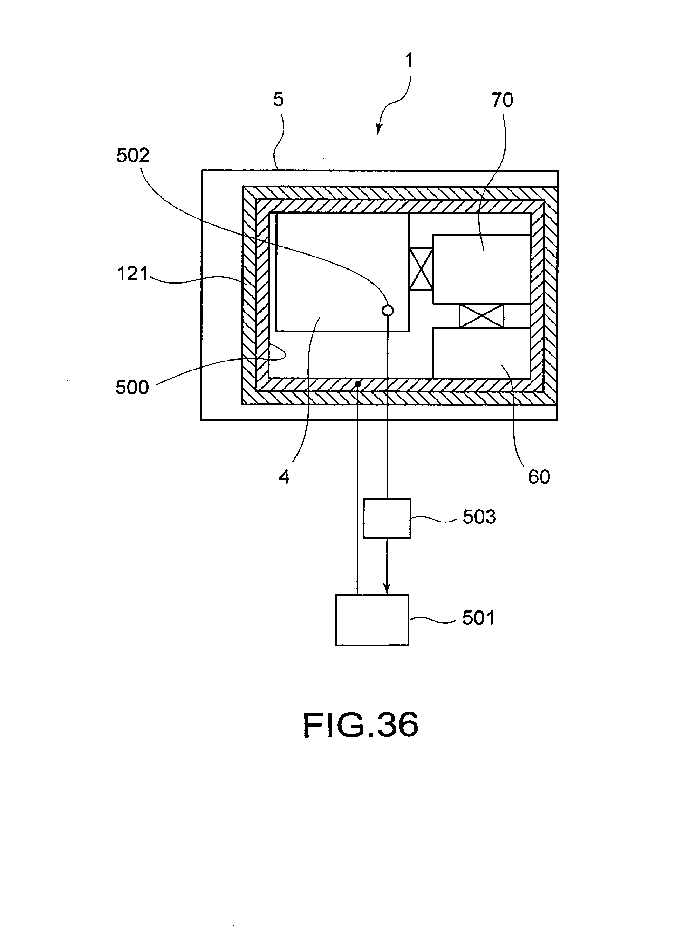

Next, a magnetic shield that suppresses magnetism entering an exposure treatment chamber 4 that emits an electron beam to a semiconductor wafer W for an exposure treatment according to another embodiment of the present invention will be described. In this embodiment, similar portions to those of the foregoing embodiment are denoted by similar reference numerals and their description will be described. As shown in Fig. 36, six surfaces, which are an upper surface, a lower surface, a left surface, a right surface, a front surface, and a rear surface of each of an exposure treatment chamber 4, a reduced pressure conveying chamber 70, and a vacuum preparation chamber 60 are covered by a magnetism penetration suppressing mechanism (first magnetic shield), for example a magnetic shield member 121 that non-magnetically shields a member made of for example perm alloy, electromagnetic soft steel, electromagnetic hard steel, Sendust, or ferrite. As described above, the exposure treatment chamber 4 is covered by the magnetic shield member 121 because an electron beam is deflected by magnetism. Thus, the magnetism shield member 121 prevents the yield of the exposure treatment for a semiconductor wafer W from lowering. Although the whole apparatus may be covered by the magnetism shield member 121, since the apparatus becomes large, such a method is neither practical, nor economical. In addition, since the apparatus has a magnetic generation source such as a control device, it is preferred that the exposure treatment chamber 4, the reduced pressure conveying chamber 70, and the vacuum preparation chamber 60 be covered by the magnetism shield member 121. Although only the exposure treatment chamber 4 may be covered by the magnetism shield member 121, magnetism generated by the reduced pressure conveying chamber 70 and the vacuum preparation chamber 60 cannot be effectively prevented. Thus, it is necessary to cover at least the exposure treatment chamber 4 and the reduced pressure conveying chamber 70 by the magnetism shield member 121. It is preferred that the exposure treatment chamber 4, the reduced pressure conveying chamber 70, and the vacuum preparation chamber 60 be covered by the magnetism shield member 121. In addition, to downsize the system, it is more preferred that only the exposure treatment chamber 4 be covered by the magnetism shield member 121.

Disposed inside the magnetic shield member 121 is a magnetism penetration suppressing mechanism (second magnetic shield), for example a magnetic shield member 500, that electromagnetically shields the inside. The magnetic shield member 500 is for example Helmholtz coils. The Helmholtz coils are disposed on the six inner surfaces, which are an upper surface, a lower surface, a left surface, a right surface, a front surface, and a rear surface of the magnetism shield member 121. A power supply 501 is connected to each surface of the magnetic shield member 500 so that a current having a predetermined current value and a predetermined frequency flows in each surface. Disposed at a predetermined position of an inner area of the magnetic shield member 500 is a magnetic sensor 502 that measures magnetism. Based on the measured result of the magnetic sensor 502, a control mechanism 503 controls the power supply 501 for a current value, frequency, and current direction for the current that flows in the magnetic shield member 500 so as to control a magnetic field generated in an inner area of the magnetic shield member 500. In this structure, the exposure treatment chamber 4 can be prevented from being affected by a magnetic field generated by an external device. Thus, the throughput of the exposure treatment can be improved. In addition, although the magnetic shield member 500 generates a magnetic field that varies, since the magnetic shield member 500 is covered by the magnetic shield member 121, the magnetic shield member 500 does not magnetically affect the outside of the apparatus. Thus, the intensity of the magnetic field in the exposing device 1 is half or less of that of the outside thereof.

Like the foregoing amplifier section 130, the power supply 501 is disposed opposite to the reduced pressure conveying chamber 70 of the exposure treatment chamber 4. The height of the power supply 501 is greater than the height h5 of the holding surface of a semiconductor wafer W on the stage 91. Preferably, the height of the power supply 501 is greater than the height h6 of a loading openings 89 as a conveying opening for the semiconductor wafer W of the exposure treatment chamber 4. More preferably, the height of the power supply 501 is greater than the height h7 of an electron beam emitted from a column 100. Otherwise, an electromagnetic wave generated from the power supply 501 affects an electron beam.

It is preferred that the magnetic sensor 502 be disposed outside the exposure treatment chamber 4 or at a predetermined position of the inside of the exposure treatment chamber 4. As long as a semiconductor wafer W exposed in the exposure treatment chamber 4 is prevented from being magnetically affected, the magnetic sensor 505 may be disposed anywhere outside the exposure treatment chamber 4 or at a predetermined position of the inside of the exposure treatment chamber 4. When the magnetic sensor 502 cannot be disposed in the exposure treatment chamber 4, data of magnetic field in the exposure treatment chamber 4 and data of magnetic field shielded by the coils controlled by the control mechanism 503 may be stored in a storage mechanism. Based on the relationship of the stored magnetic data and the magnetic sensor 502 disposed outside the exposure treatment chamber 4, the coils may be controlled.

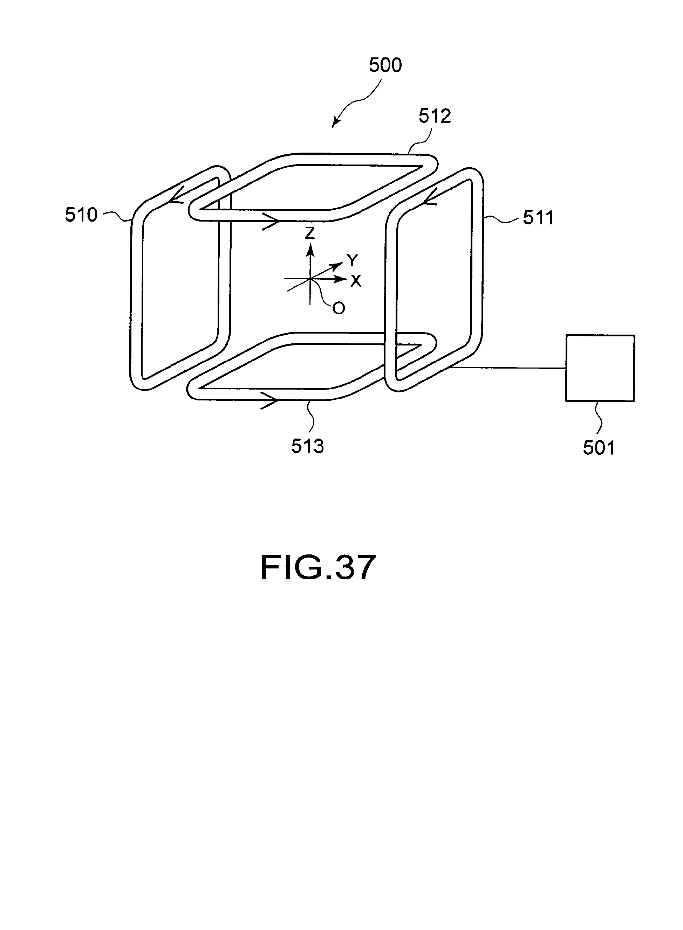

As shown in Fig. 37, with respect to controls of the Helmholtz coils, a left coil 510, a right coil 511, an upper coil 512, and a lower coil 513 are disposed (for convenience, description of a front coil and a rear coil will be omitted). Currents that flow in the same direction (arrow directions in Fig. 37) are supplied from the power supply 501 to a pair of coils that face each other, for example the left coil 510 and the right coil 511. Likewise, currents that flow in the same direction (arrow direction in Fig. 37) are supplied from the power supply 501 to another pair of coils that face each other, for example the upper coil 512 and the lower coil 513. Of course, this applies to another pair that face each other, for example the front coil and the rear coil. However, with respect to frequency, current value, and/or DC (Direct Current component) value, it is preferred that the coils be controlled by the control mechanism 503 in different condition, for example the frequency and/or current value of for example the left coil 510 is different from that of the right coil 511 or the frequency, current value, and/or DC value of the right coil 511 and the left coil 510 is different from that of the upper coil 512 and the lower coil 513 so that the magnetic field at a predetermined position, for example position 0, becomes a predetermined value, for example 0. In the foregoing description, for convenience, only the left coil 510, the right coil 511, the upper coil 512, and the lower coil 513 were controlled. However, of course, the coils including the front coil and the rear coil need to be properly controlled. These coils need to be controlled on the X, Y, and Z-axes so that the magnetic field at the predetermined position 0 becomes a predetermined value.

When necessary, the Helmholtz coils need to be controlled based on an electric charge that is present in the electrostatic chuck and that is measured by an ammeter 320 of the electrostatic chuck or pre-stored data.

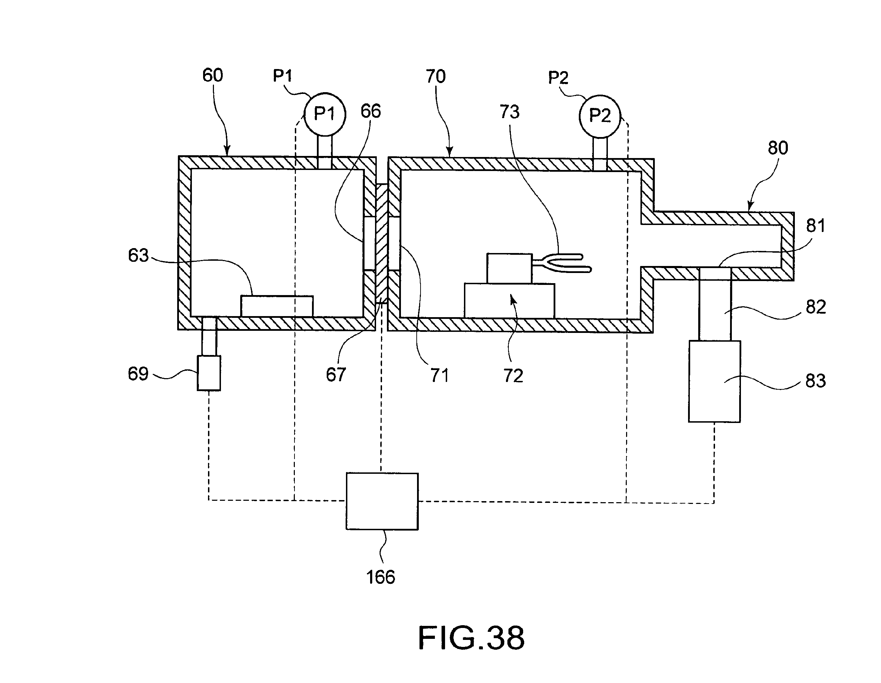

Next, venting and conveying processes of a reduced pressure conveying chamber 70 and a vacuum preparation chamber 60 according to another embodiment of the present invention will be described. In this embodiment, similar portions to those of the foregoing embodiment are denoted by similar reference numerals and their description will be omitted. Steps of the venting and conveying processes of the reduced pressure conveying chamber 70 and the vacuum preparation chamber 60 will be described with reference to Fig. 38, Fig. 39, and Fig. 40. Pressure gauges P1 and P2 are connected to the reduced pressure conveying chamber 70 and the vacuum preparation chamber 60, respectively. The pressure gauges P1 and P2 can freely measure the inner pressures of the reduced pressure conveying chamber 70 and the vacuum preparation chamber 60, respectively. Measured data of the pressure gauges P1 and P2 are sent to the control mechanism 166.

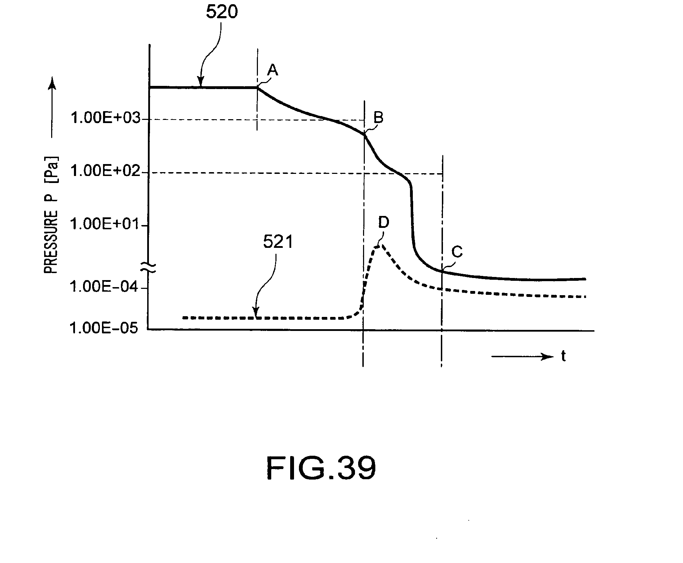

Next, a process of conveying a semiconductor wafer W from the vacuum preparation chamber 60 to the reduced pressure conveying chamber 70 will be described. When the semiconductor wafer W is conveyed to the vacuum preparation chamber 60, the semiconductor wafer W is conveyed in atmospheric pressure or positive pressure higher than atmospheric pressure. Thus, immediately after the semiconductor wafer W has been conveyed to the vacuum preparation chamber 60, the inner pressure thereof becomes atmospheric pressure or positive pressure higher than atmospheric pressure. This pressure value lasts from the beginning to a point A on a curve 520 as a measured value of the pressure gauge P1 as shown in Fig. 39. Thereafter, the vacuum preparation chamber 60 is vented by a venting mechanism 69 until the inner pressure of the vacuum preparation chamber 60 becomes a predetermined pressure value in the range from 1.00E+10² to 1.00E+10³ (Pa) at a point B on the curve 520 shown in Fig. 39.

When the inner pressure becomes the predetermined value at the point B on the curve 520 shown in Fig. 39, an opening and closing mechanism 67 disposed between the vacuum preparation chamber 60 and the reduced pressure conveying chamber 70 is opened. As a result, the inner pressure of the reduced pressure conveying chamber 70 rises to a value D on a curve 521 shown in Fig. 39 as a measured value of the pressure gauge P2. In contrast, the inner pressure of the vacuum preparation chamber 60 drops as the curve 520 shown in Fig. 39. After a point C, the inner pressure of the vacuum preparation chamber 60 and the inner pressure of the reduced pressure conveying chamber 70 become stable.

In these processes, at the point B on the curve 520 shown in Fig. 39, the control mechanism 166 causes the venting mechanism 69 to stop or controls the opening and closing mechanism, for example a valve, to close the vent line and the venting mechanism 83 to vent the vacuum preparation chamber 60 and the reduced pressure conveying chamber 70, not stop the venting mechanism 69 at the point B on the curve 520 shown in Fig. 39. After the inner pressures of the vacuum preparation chamber 60 and the reduced pressure conveying chamber 70 have been set at the same pressure by the venting mechanisms 69 and 83, respectively, the opening and closing mechanism 67 disposed between the vacuum preparation chamber 60 and the reduced pressure conveying chamber 70 may be opened. However, to lower the inner pressure of the vacuum preparation chamber 60 to the same pressure as the inner pressure of the reduced pressure conveying chamber 70, it is necessary to increase the venting capability, namely the size, of the venting mechanism 69 that vents the vacuum preparation chamber 60. Alternatively, it is necessary to provide a highly vacuum venting mechanism, for example a turbo molecular pump (TMP). However, to downsize the system, it is preferred that the venting mechanism 69 vent the vacuum preparation chamber 60 to a predetermined pressure value and the vacuum pump 83 vent the reduced pressure conveying chamber 70 to the desired pressure value. As a result, the system can be downsized. Thus, it is preferred that the system be downsized without a highly vacuum venting mechanism.

In the foregoing process, until the point B on the curve 520 shown in Fig. 39, preferably from the point A to the point B, the position of a semiconductor wafer W is measured in the vacuum preparation chamber 60 by the CCD cameras 65 and position information is obtained (see Fig. 6). After the point C on the curve 520 shown in Fig. 39, the semiconductor wafer W is conveyed from the vacuum preparation chamber 60 to the reduced pressure conveying chamber 70 by the conveying mechanism 72. In addition, from the point B to the point C on the curve 520 shown in Fig. 39, for reliability of conveyance, it is important to monitor the position information of the CCD cameras 65 (see Fig. 6) with which it is determined whether the semiconductor wafer W is displaced due to fluctuation of pressure. On the curve 521 shown in Fig. 39, the inner pressures of the reduced pressure conveying chamber 70 vary in such a manner that the semiconductor wafer W is held in the vacuum preparation chamber 60 in a first pressure value (up to the point B), the semiconductor wafer W is conveyed from the vacuum preparation chamber 60 to the reduced pressure conveying chamber 70 by the conveying mechanism 72 in a second pressure value higher than the first pressure value (at the point C), and the semiconductor wafer W is conveyed to the exposure treatment chamber 4 in a third pressure value that is nearly equal to or lower than the second pressure value.

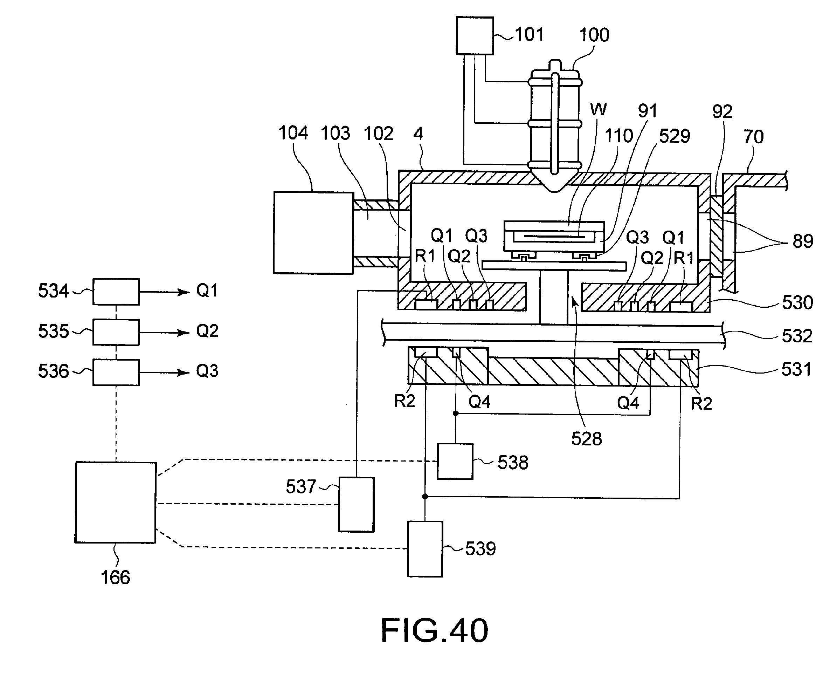

Next, an exposure treatment chamber 4 according to another embodiment of the present invention will be described. In this embodiment, similar portions to those in the foregoing embodiment are denoted by similar reference numerals and their description will be omitted. As shown in Fig. 40, a stage 91 is disposed in the exposure treatment chamber 4. In the exposure treatment chamber 4, the stage 91 is freely moved in directions of one axis, for example the Y-axis, by a Y-axis driving mechanism 529. Disposed on a lower wall 530 of the exposure treatment chamber 4 is an opening portion 528 in which a slider 532 as an X-axis driving mechanism that moves the stage 91 along with the Y-axis driving mechanism 529 in directions of one axis, for example the X-axis. Disposed below the slider 532 as a bearing is also a bottom wall 531.

Disposed on the slider 532 side of the lower wall 530 are a plurality of venting nozzles Q1, Q2, and Q3. These venting nozzle Q1, Q2, and Q3 are freely vented by venting mechanisms 534, 535, and 536, respectively. Of course, the venting nozzles Q1, Q2, and Q3 may be shared by at least one venting mechanism. It is preferred that the venting nozzles Q1 and Q2 be vented by one venting mechanism and the venting nozzle Q3 be vented by another venting mechanism so that the amount of gas vented of the venting nozzle Q3 is greater than that of the venting nozzles Q1 and Q2 for a predetermined degree of vacuum. Disposed outside the plurality of venting nozzles Q1, Q2, and Q3 on the lower wall 530 and opposite to the slider 532 is a jet nozzle R1 that jets a predetermined gas, for example clean air or inert gas such as nitrogen, supplied from an gas supplying mechanism 537.

Disposed on the bottom wall 531 opposite to the slider 532 corresponding to the venting nozzle Q1 is a venting nozzle Q4 that can be freely vented by a venting mechanism 538. Disposed outside the venting nozzle Q4 on the bottom wall 531 opposite to the slider 532 corresponding to the jet nozzle R1 is a jet nozzle R2. The jet nozzle R2 jets a predetermined gas, for example clean gas or inert gas such as nitrogen gas, supplied from a gas supplying mechanism 539. Although the venting nozzle Q4 is disposed opposite to the venting nozzle Q1, the venting nozzle Q4 may be disposed opposite to the venting nozzle Q2. Instead, a plurality of venting nozzles Q4 may be disposed opposite to the venting nozzles Q1 and Q2. However, it is preferred that the number of venting nozzles disposed on the lower wall 530 be greater than the number of venting nozzles disposed on the bottom wall 531. In addition, although the venting nozzles disposed on the bottom wall 531 are opposite to the venting nozzles disposed on the lower wall 530, as long as the similar object can be accomplished, they do not need to be disposed at the opposite positions.

The gas supplying mechanisms 537 and 539 and the venting mechanisms 534, 535, 536, and 538 can be freely controlled by the control mechanism 166. In such a manner, the slider 532 contacts neither the bottom wall 531, nor the lower wall 530. The inner and outer seal portions of the exposure treatment chamber 4 are structured as a differential vent shield. Since the differential vent seal is made up of one axis disposed in the exposure treatment chamber 4 and another axis disposed outside the exposure treatment chamber 4, the volume of the exposure treatment chamber 4 can be decreased. Thus, since the venting speed can be increased, the throughput of the process can be improved. In addition, since the volume of the exposure treatment chamber 4 can be decreased, the apparatus can be downsized.

Next, the operation of the seal section will be described. To accomplish the differential vent seal, the exposure treatment chamber 4 is vented through the venting nozzles Q1, Q2, Q3, and Q4 that have predetermined amounts of gas vented, gases are jetted through the jet nozzles R1 and R2 having predetermined flow rates, and the slider 532 is not contacted to the bottom wall 531 and the lower wall 530. It is preferred that the pressure values of the venting nozzles Q1, Q2, and Q3 to the slider 532 be several hundred Toll, several Toll, and several mm Toll, respectively (the pressure values are decreased on the order of 10²).

Although the differential vent seal section regularly operates, if the power of the apparatus is turned off in an abnormal situation such as an emergency stop or a power failure, outer air will flow to the exposure treatment chamber 4 without particular countermeasures. In this case, the exposure treatment chamber 4 need to be extensively cleaned as a maintenance work. In addition, if a semiconductor wafer W is present in the exposure treatment chamber 4, the semiconductor wafer W will become a defective product. Thus, as a process of preventing such a trouble, the control mechanism 166 sends a command to the gas supplying mechanism 537 to stop jetting gas from the jet nozzle R1 of the lower wall 530 as a bearing. If a power failure or an emergency stop occurs, since the power supply of the exposure treatment chamber 4 is turned off, it is necessary to take countermeasures for driving the gas supplying mechanism 537 using a spare battery such as a uninterruptible power supply.

Since gas is stopped from the jet nozzle R1, the slider 532 contacts the venting nozzles Q1, Q2, and Q3. As a result, the interior of the exposure treatment chamber 4 is kept in an airtight state. When the control mechanism 166 detects this state by measuring the inner pressure of the exposure treatment chamber 4 using a pressure gauge or the like, the control mechanism 166 turns off the power.

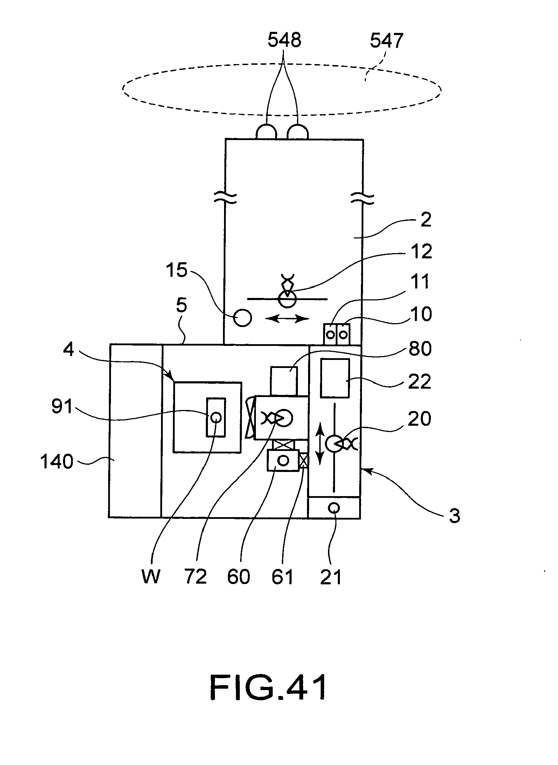

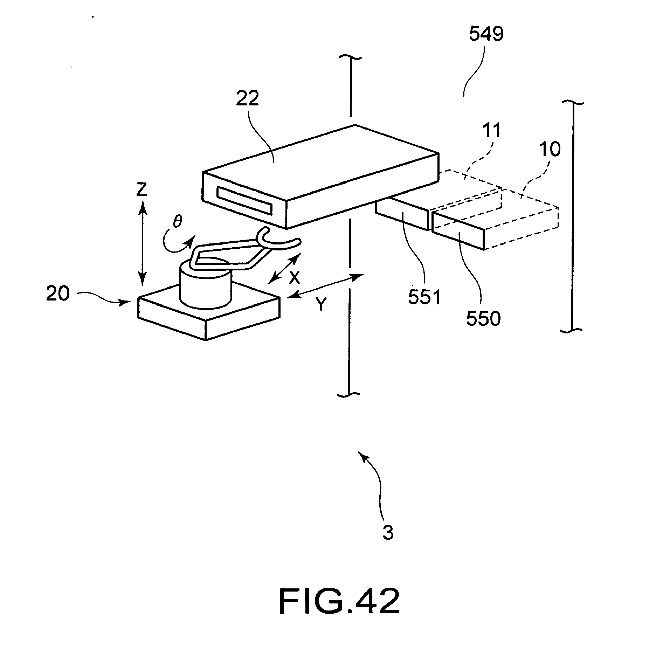

Next, a system according to another embodiment of the present invention will be described. The structure of the system according to this embodiment is similar to that of the system shown in Fig. 1. In this embodiment, similar reference numerals to those of the foregoing embodiment shown in Fig. 1 are denoted by similar reference numerals and their description will be omitted. As shown in Fig. 41 and Fig. 42, the system as an exposing device 1 can be inline connected to another device such as a resist treatment device 2 having a coating device that coats resist solution on the treatment surface of a substrate under treatment, for example a semiconductor wafer W, and a developing device that develops the resist film formed on the treatment surface of the semiconductor wafer W through an atmospheric aligner section 3. In this example, the resist treatment device 2 is disposed on the non-opposite side of the exposing device 1 and on one shorter side of the atmospheric aligner section 3 (in parallel with the row of the vacuum preparation chamber 60 and the reduced pressure conveying chamber 70). The system is arranged so that the width of a working area 547 of the clean room or the like is decreased and the cost of the facility of the plant is decreased or the cleanliness of the working area is improved. In this arrangement, a cassette 548 that contains a plurality of semiconductor wafers W is disposed on the resist treatment device 2 side.

In this arrangement, as shown in Fig. 42, when a semiconductor wafer W is transferred from the conveying mechanism 20 of the atmospheric aligner section 3 to the resist treatment device 2, the semiconductor wafer W is received from a passing portion 10 and passed to a receiving portion 11 disposed on the resist treatment device 2 through opening portions 550 and 551 formed on a wall 549 on a shorter side of the atmospheric aligner section 3. When a semiconductor wafer W is received from the receiving portion 11 and passed to the passing portion 10 disposed on the resist treatment device 2 side through the opening portions 550 and 551, the conveying mechanism 20 is moved below the heat treatment section 22. In this structure, the semiconductor wafer W conveyed by the conveying mechanism 20 can be prevented from being thermally affected by the heat treatment section 22.

Although the present invention has been shown and described with respect to best mode embodiments thereof, it should be understood by those skilled in the art that the foregoing and various other changes, omissions, and additions in the form and detail thereof may be made therein without departing from the spirit and scope of the present invention. For example, in the foregoing embodiments, a semiconductor wafer was described as a substrate under treatment. Instead, a substrate such as an LCD substrate may be used. In the foregoing embodiments, a dual-electrode chuck system using a plurality of electrodes as an electrostatic chuck mechanism was exemplified. Instead, a single-electrode check system using one electrode may be used. When necessary, the dual-electrode chuck system or the single-electrode chuck system may be flexibly used.

In the foregoing embodiments, conductive needles are disposed on the treatment surface and the rear surface of a substrate under treatment. Instead, a conductive needle may be disposed only on the treatment surface or the rear surface of a substrate under treatment. Within the scope of the present invention, when applicable, one of these structures may be flexibly used.

As one embodiment of the present invention, the atmospheric aligner section and the exposure treatment section are structured as a system. As another embodiment of the present invention, the atmospheric aligner section, the resist treatment device, and the exposure treatment section are structured as a system. Instead, the atmospheric aligner section and another device may be structured as a system. Instead, the atmospheric aligner section may be disposed between other devices and they may be structured as a system. Instead, the atmospheric aligner section may be structured as an independent system. In addition, the conductive needles disposed on the treatment surface and the rear surface of a substrate under treatment are raised and lowered by independent raising and lowering mechanisms. Instead, these conductive needles may be formed in for example a clip-shape and one raising and lowering mechanism may contact the clip-shaped conductive needles to the treatment surface and the rear surface of the substrate under treatment. The inclined portion of the conveying opening of the reduced pressure conveying chamber 70 is tapered so that the upper surface of the conveying opening is shorter than the lower surface thereof. Instead, the inclined portion may be reversely tapered so that the lower surface is smaller than the upper surface.

## Claims

1. A substrate treatment apparatus, comprising:
an electrostatic chuck mechanism which electrostatically sucks and holds a substrate under treatment;
a first grounding mechanism which freely contacts a predetermined film of a plurality of films formed on a treatment surface of the substrate under treatment at a first position on the treatment surface side of the substrate under treatment sucked and held by the electrostatic chuck mechanism;
a second grounding mechanism which freely contacts the substrate under treatment at a second position on the rear surface side of the substrate under treatment sucked and held by the electrostatic chuck mechanism, the second position being opposite to the first position, the second position deviating from the first position;
an electrostatic chuck mechanism which is disposed on a holding table, and the temperature of the holding table which is nearly equal to or lower than an inner temperature of a reduced pressure preparation chamber before the substrate under treatment is loaded into an exposure treatment chamber, an inner temperature of a substrate loading and unloading section, an inner temperature of a substrate conveying chamber, an inner temperature of another device which is inline connected to the substrate treatment apparatus, and/or an inner temperature of a transferring section for the substrate under treatment of the other device inline connected to the substrate treatment apparatus; and
an electron beam radiating mechanism which radiates a resist film formed on the treatment surface side of the substrate under treatment with an electron beam.

2. The substrate treatment apparatus as set forth in claim 1, further comprising:
an eddy current suppressing mechanism which is disposed around the substrate under treatment sucked by the electrostatic chuck mechanism and which suppresses occurrence of an eddy current in the substrate under treatment.

3. The substrate treatment apparatus as set forth in claim 1 or claim 2, further comprising:
an alignment mechanism which aligns the substrate under treatment on an upper position of the electrostatic chuck mechanism.

4. The substrate treatment apparatus as set forth in claim 1, claim 2 or claim 3,
wherein the predetermined film of the plurality of films is an anti-static film or a conductive film.

5. The substrate treatment apparatus as set forth in claim 1, claim 2, claim 3, or claim 5,
wherein the second grounding mechanism contacts a constituent material of the substrate under treatment or a compound film thereof.

6. A substrate treatment method of performing an exposing treatment for a substrate under treatment, comprising the steps of:
causing a grounding mechanism to contact a grounding mechanism at a first position on a treatment surface side of the substrate under treatment;
causing an electrostatic chuck mechanism disposed on a holding table to electrostatically suck the substrate under treatment, wherein a temperature of the holding table is nearly equal to or lower than an inner temperature of a reduced pressure preparation chamber before the substrate under treatment is loaded into an exposure treatment chamber, an inner temperature of a substrate loading and unloading section, an inner temperature of a substrate conveying chamber, an inner temperature of another inline connected device, and/or an inner temperature of a transferring section for the substrate under treatment of the other inline connected device;
causing the grounding mechanism to contact the substrate under treatment at a second position on the rear surface side of the substrate under treatment sucked and held by the electrostatic chuck mechanism, the second position being opposite to the first position, the second position deviating from the first position; and
performing an exposing treatment for the substrate under treatment.

7. The substrate treatment method as set forth in claim 6,
wherein the second position is closer to the center position of the substrate under treatment than the first position on the treatment surface side of the substrate under treatment.

8. The substrate treatment method as set forth in claim 6 or claim 7,
wherein the first position that the grounding mechanism contacts the substrate under treatment is a holding area of the holding table on which the substrate under treatment is held and an area without a position of an electrode of the electrostatic chuck mechanism.

9. The substrate treatment method as set forth in claim 6, claim 7 or claim 8,
wherein the grounding mechanism on the treatment surface side is at least a conductive film or an antistatic film of a plurality of films formed on the treatment surface of the substrate under treatment, and
wherein the second grounding mechanism contacts a constituent material of the substrate under treatment or a compound film thereof on the rear surface of the substrate under treatment.

10. The substrate treatment method as set forth in claim 6, claim 7, claim 8 or claim 9, further comprising the step of:
aligning the substrate under treatment on an upper position of the electrostatic chuck mechanism before holding the substrate under treatment on the holding table.
